(19) Europäisches Patentamt
European Patent Office
Office européen des brevets

(11) EP 1 582 340 A1

(12) **EUROPEAN PATENT APPLICATION**
published in accordance with Art. 158(3) EPC

(43) Date of publication:
**05.10.2005 Bulletin 2005/40**

(21) Application number: **03782886.0**

(22) Date of filing: **25.12.2003**

(51) Int Cl.[7]: **B32B 5/18**, B32B 27/08

(86) International application number:
**PCT/JP2003/016702**

(87) International publication number:
**WO 2004/060656 (22.07.2004 Gazette 2004/30)**

(84) Designated Contracting States:
**AT BE BG CH CY CZ DE DK EE ES FI FR GB GR HU IE IT LI LU MC NL PT RO SE SI SK TR**

(30) Priority: **06.01.2003 JP 2003000220**
**27.05.2003 JP 2003148825**

(71) Applicant: **TORAY INDUSTRIES, INC.**
**Tokyo 103-8666 (JP)**

(72) Inventors:
- **HIGASHIOJI, Takuji**
  **Kyoto-shi, Kyoto 607-8088 (JP)**
- **TSUNEKAWA, Tetsuya**
  **Otsu-shi, Shiga 520-2134 (JP)**
- **MACHIDA, Tetsuya**
  **Otsu-shi, Shiga 520-0842 (JP)**
- **NAKAMORI, Yukari**
  **Koka-gun, Shiga 529-1851 (JP)**

(74) Representative: **Kador & Partner**
**Corneliusstrasse 15**
**80469 München (DE)**

# (54) LAMINATED FILM AND METHOD FOR PRODUCING SAME

(57) A laminated film which is excellent in thermal dimensional stability, cushion properties and low dielectric characteristics is disclosed. The laminated film comprises at least two layers among which at least one layer is a biaxially oriented film composed of a thermoplastic resin composition and at least one other layer is a film having a network structure.

FIG. 2

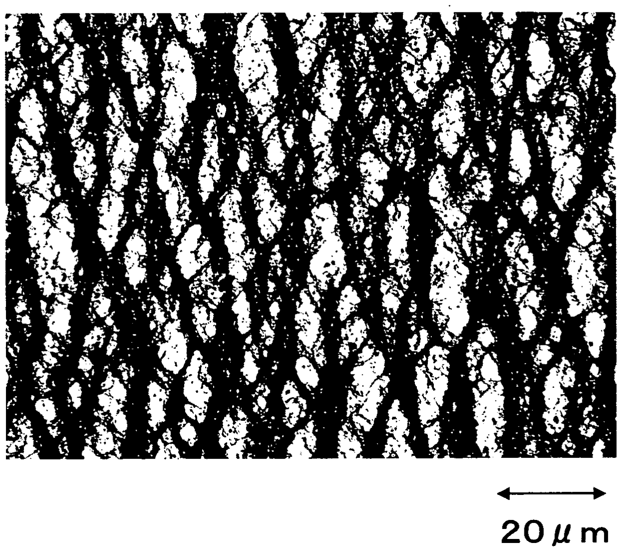


EP 1 582 340 A1

## Description

Technical Field

The present invention relates to laminated films. The present invention particularly relates to laminated films useful for various industrial applications such as circuit substrates, magnetic recording media, process sheets, release liners, plate-making materials, optical display materials, molding materials, building materials, and electrically insulating materials.

Background Art

Films are used for various applications, in massive demand, such as agricultural materials, packaging materials, building material, and industrial materials including magnetic recording media, circuit materials, plate making/printing materials, process/release materials, printing materials, molding materials, and electrically insulating materials.
High-performance films have been recently demanded for such applications.
In recent years, demands for flexible printed circuits (FPCs) have increased as electronic devices such as mobile phones have increased in performance. Since such devices have been reduced in size and weight, the FPCs have been reduced in thickness. Therefore, copper-clad polyimide films for the FPCs and copper layers included in such films have been also reduced in thickness. This leads to a reduction in film stiffness, resulting in difficulty in processing the films during the manufacture of the FPCs. In order to readily handle the films during processing, the following technique is used: slightly adhesive supporting films that can be peeled off or removed after processing are attached to the polyimide films such that the resulting polyimide films have increased stiffness. Examples of such supporting films include polyester films. A method for manufacturing an FPC using such a technique includes a step of hot-pressing a copper-clad polyimide film having a supporting film attached thereto, a step of curing the polyimide film, and/or a step of mounting IC chips on the polyimide film. Since a polyester film has a thermal expansion coefficient greater than that of the copper-clad polyimide film and is therefore inferior in thermal dimensional stability as compared to the polyimide film, the following problem occurs during steps of manufacturing the FPC: the polyimide film is warped or reduced in flatness due to the thermal distortion of the polyester film.
In electrical or electronic component applications, polyphenylene sulfide films are expected to be useful in manufacturing circuit substrates because the films have high heat resistance and are only slightly varied in size when the films absorb water; however, there is a problem in that the films have a large thermal expansion coefficient. In order to solve the problem, the following techniques are disclosed: techniques for using glass fibers or particulate inorganic fillers (see Patent Documents 1 and 2). However, these techniques are problematic in that satisfactory improvements cannot be achieved, film flatness and/or smoothness is unsatisfactory, and manufacturing cost is high.
Flooring materials for buildings need to have high thermal insulation properties and good cushion properties in some cases. Although polyolefin foam is a material having high thermal insulation properties and good cushion properties include polyolefin foam, it is difficult to process the foam into thin films. Therefore, the polyolefin foam is useless in manufacturing heat insulation cushions and has limited uses. Hence, thin films having high thermal insulation properties and good cushion properties have been demanded.
Films for print materials such as image-forming materials and printout materials for printers need to have good cushion properties. The following films are disclosed: porous films prepared by mixing polyester, a thermoplastic resin other than polyester, and inorganic particles and then stretching the mixture (see Patent Documents 3, 4, and 5). These films are problematic in that they have unsatisfactory dimensional stability and flexibility.
Since recent high-performance electronic devices need to process digital signals at high speed, films used for such applications need to have high performance. In order to reduce dielectric loss during transmission, thermoplastic resin films for insulating flexible printed circuits, cable insulation jackets, and motor transformer components need to have low dielectric constant and dielectric loss tangent, which are electrical characteristics necessary to cope with high frequencies due to high-speed signal processing. In particular, apparatuses including rotating units such as motors are inverter-controlled such that the apparatuses are precisely controlled to achieve high efficiency and high performance. This leads to an increase in the amount of high-frequency currents leaking from insulating materials.
In order to obtain insulating films with low dielectric constant, a technique for forming independent pores is used because the dielectric constant of gas is low, one.
Examples of such a technique include (a) a technique for forming pores using a blowing agent (see Patent Document 6), (b) a technique for forming micropores by blending polymers incompatible with each other and then stretching the blend (see Patent Documents 7 and 8), and (c) a technique for forming micropores by subjecting a polymer blend containing two or more thermoplastic polymers to spinodal decomposition to make phase separation occur and removing at least one of the polymers by etching, thermolysis, or alkali decomposition (see Patent Document 9).
A thermoplastic polymer film prepared by technique (a) has portions having different dielectric constants due

to the nonuniform distribution of the pores and has low formability and heat resistance due to the blowing agent used to form the pores. For a thermoplastic polymer film prepared by technique (b), the distribution of the micropores is nonuniform and the formability is low because the blending of the incompatible polymers cannot be sufficiently controlled. For a thermoplastic polymer film prepared by technique (c), a process for manufacturing this film is complicated and is not therefore suitable for practical use because at least one of the polymers must be removed so as to form the micropores.

Patent Document 1: Japanese Unexamined Patent Application Publication No. 5-310957
Patent Document 2: Japanese Patent No. 2952923
Patent Document 3: Japanese Examined Patent Application Publication No. 6-96281
Patent Document 4: Japanese Unexamined Patent Application Publication No. 2-29438
Patent Document 5: Japanese Unexamined Patent Application Publication No. 6-322153
Patent Document 6: Japanese Patent No. 3115215
Patent Document 7: Japanese Unexamined Patent Application Publication No. 9-286867
Patent Document 8: Japanese Unexamined Patent Application Publication No. 11-92577
Patent Document 9: Japanese Unexamined Patent Application Publication No. 2003-64214

It is an object of the present invention to provide films having high thermal dimensional stability, good cushion properties, and low dielectric properties.
Patent Documents 10 and 11 disclose films containing polyester and a liquid-crystalline polymer dispersed therein. However, network structures, cracks, and/or pores described below are not disclosed in these patent documents.

Patent Document 10: Japanese Unexamined Patent Application Publication No. 10-298313
Patent Document 11: Japanese Unexamined Patent Application Publication No. 11-5855

Disclosure of Invention

The present invention provides the following films, method, and materials:

(1) A laminated film including at least two film layers, wherein at least one of the film layers contains a thermoplastic resin composition and is biaxially oriented and at least another one of the film layers includes a network structure.
(2) The laminated film specified in item (1), wherein the biaxially oriented film layers containing the thermoplastic resin composition are placed on both faces of the network structure-including film layer.
(3) The laminated film specified in item (1) or (2), wherein the network structure-including film layer contains a nonductile resin composition.
(4) The laminated film specified in any one of items (1) to (3), wherein the network structure-including film layer contains a liquid-crystalline polymer.
(5) The laminated film specified in item (4), wherein the network structure-including film layer further contains non-liquid-crystalline polyester.
(6) The laminated film specified in item (5), wherein the non-liquid-crystalline polyester is polyethylene terephthalate, polyethylene naphthalate, or a derivative of one of these polyesters.
(7) The laminated film specified in any one of items (4) to (6), wherein the content of the liquid crystal polymer in the network structure-including film layer is 20 to 90 percent by weight.
(8) The laminated film specified in any one of items (4) to (7), wherein the content of the liquid-crystalline polymer in the laminated film is three to 30 percent by weight.
(9) The laminated film specified in any one of items (1) to (8), wherein the network structure-including film layer has a thickness equal to 1% to 90% of the thickness of the laminated film.
(10) The laminated film specified in item (9), wherein the network structure-including film layer has a thickness equal to 10% to 80% of the thickness of the laminated film.
(11) The laminated film specified in any one of items (1) to (10), wherein the thermoplastic resin composition contained in the biaxially oriented film layers contains at least one selected from the group consisting of polyester, polyphenylene sulfide, polyether imide, polycarbonate, polyether ketone, polyethersulfone, polysulfone, and polylactic acid.
(12) The laminated film specified in any one of items (1) to (11), wherein the longitudinal Young's modulus and transverse Young's modulus thereof are 2 to 7 GPa.
(13) The laminated film specified in any one of items (1) to (12), wherein the longitudinal heat shrinkage and transverse heat shrinkage thereof are 0% to 2% at 150°C.

(14) The laminated film specified in any one of items (1) to (13), wherein the longitudinal thermal expansion coefficient and transverse thermal expansion coefficient thereof are 3 to 45 ppm/°C.

(The laminated film specified items (1) to (14) is referred to as a first laminated film of the present invention.)

(15) A laminated film with a density of 0.2 to 1.2, including at least two film layers, wherein at least one of the film layers contains a thermoplastic resin composition and is biaxially oriented and at least another one of the film layers contains a non-ductile resin composition.

(16) The laminated film specified in item (15), wherein the biaxially oriented film layers are placed on both faces of the non-ductile resin composition-containing film layer.

(17) The laminated film specified in item (15) or (16), wherein the non-ductile resin composition contains a liquid-crystalline polymer.

(18) The laminated film specified in item (17), wherein the non-ductile resin composition further contains non-liquid-crystalline polyester.

(19) The laminated film specified in item (18), wherein the non-liquid-crystalline polyester is polyethylene terephthalate, polyethylene naphthalate, or a derivative of one of these polyesters.

(20) The laminated film specified in any one of items (17) to (19), wherein the content of the liquid-crystalline polymer in the non-ductile resin composition is 20 to 90 percent by weight.

(21) The laminated film specified in any one of items (17) to (20), wherein the content of the liquid-crystalline polymer in the laminated film is three to 30 percent by weight.

(22) The laminated film specified in any one of items (15) to (21), wherein the non-ductile resin composition-containing film layer has a thickness equal to 1% to 90% of the thickness of the laminated film.

(23) The laminated film specified in item (22), wherein the non-ductile resin composition-containing film layer has a thickness equal to 10% to 80% of the thickness of the laminated film.

(24) The laminated film specified in any one of items (15) to (23), wherein the thermoplastic resin composition contained in the biaxially oriented film layers contains at least one selected from the group consisting of polyester, polyphenylene sulfide, polyether imide, polycarbonate, polyether ketone, polyethersulfone, polysulfone, and polylactic acid.

(25) The laminated film specified in any one of items (15) to (24), wherein the longitudinal Young's modulus and transverse Young's modulus thereof are 2 to 7 GPa.

(26) The laminated film specified in any one of items (15) to (25), wherein the longitudinal heat shrinkage and transverse heat shrinkage thereof are 0% to 2% at 150°C.

(27) The laminated film specified in any one of items (15) to (26), wherein the longitudinal thermal expansion coefficient and transverse thermal expansion coefficient thereof are 3 to 45 ppm/°C.

(The laminated film specified items (15) to (27) is referred to as a second laminated film of the present invention.)

(28) A method for producing a laminated film, including a step of coextruding at least two resin compositions, one of the compositions being thermoplastic, another one being non-ductile, and a step of forming cracks in a layer containing the non-ductile resin composition by biaxial stretching.

(29) The method specified item (28), wherein the thermoplastic resin composition is contained in layers placed on both faces of the non-ductile resin composition-containing layer.

(30) A circuit material including the laminated film specified in any one of items (1) to (27) .

(31) A release material including the laminated film specified in any one of items (1) to (27) .

(32) An electrically insulating material including the laminated film specified in any one of items (1) to (27).

According to the present invention, a film having satisfactory thermal dimensional stability, cushion properties, and dielectric properties can be obtained.

Brief Description of the Drawings

FIG. 1 is a schematic view showing a typical network structure present in a layer included in a laminated film of the present invention.

FIG. 2 is a microscope photograph of a network structure present in an A layer included in a laminated film prepared in Example 1.

Best Mode for Carrying Out the Invention

A laminated film of the present invention includes at least two film layers and at least one of the layers contains a thermoplastic resin composition.

The thermoplastic resin composition contains a polymer that can be biaxially stretched. Examples of such a polymer include polyester, polyarylate, polyphenylene sulfide, polyimide, polyether imide, polyamide, polyamidoimide, modified polyphenylene oxide, polycarbonate, polypropylene, polyethylene, polyether ketone, polyketone, polyethersulfone, polysulfone, polylactic acid, and copolymers of these polymers. A blend containing at least one of these polymers may be used. In the present invention, in view of biaxial stretchability and the advantages of the present invention, the following polymers are preferable: polyester, polyphenylene sulfide, polyether imide, polycarbonate, polyether ketone, polyethersulfone, polysulfone, and polylactic acid. In particular, polyester and polyphenylene sulfide are preferable. Polyester is especially preferable.

Polyester is useful in continuously producing large-area films, which cannot be produced using other materials. Since such films are superior in strength, durability, transparency, flexibility, and surface property, the films can be used for various applications.

A polyester used herein preferably contains a constituent derived from an acid such as aromatic dicarboxylic acid, alicyclic dicarboxylic acid, or aliphatic dicarboxylic acid and a constituent derived from a diol.

Examples of the aromatic dicarboxylic acid include terephthalic acid, isophthalic acid, phthalic acid, 1,4-naphthalene dicarboxylic acid, 1,5-naphthalene dicarboxylic acid, 2,6-naphthalene dicarboxylic acid, benzophenone dicarboxylic acid, 4,4'-diphenyl dicarboxylic acid, 3,3'-diphenyl dicarboxylic acid, 4,4'-diphenyl ether dicarboxylic acid, and 4,4'-diphenylsulfone dicarboxylic acid. In particular, terephthalic acid, phthalic acid, and 2,6-naphthalene dicarboxylic acid are preferable. Examples of the alicyclic dicarboxylic acid include hexahydroterephthalic acid, 1,3-adamantane dicarboxylic acid, and cyclohexane dicarboxylic acid. Examples of the aliphatic dicarboxylic acid include adipic acid, succinic acid, azelaic acid, suberic acid, sebacic acid, and dodecanedioic acid. Those acids may be used alone or in combination and oxyacid such as hydroxy ethoxy benzoic acid may be copolymerized with one of those acids.

Examples of the diol include aromatic diols such as chlorohydroquinone, methylhydroquinone, 4,4'-dihydroxybiphenyl, 4,4'-dihydroxydiphenyl sulfone, 4,4'-dihydroxydiphenyl sulfide, 4,4'-dihydroxybenzophenone, and p-xylylene glycol; ethylene glycol; 1,2-propane diol; 1,3-propane diol; neopentyl glycol; 1,3-butane diol; 1,4-butane diol; 1,5-pentane diol; 1,6-hexane diol; 1,2-cyclohexane dimethanol; 1,3-cyclohexane dimethanol; 1,4-cyclohexane dimethanol; diethylene glycol; triethylene glycol; polyalkylene glycol; and 2,2'-bis(4'-β-hydroxyethoxyphenyl)propane. In particular, ethylene glycol, 1,4-butane diol, 1,4-cyclohexane dimethanol, and diethylene glycol are preferable. Ethylene glycol is particularly preferable. Those diols may be used alone or in combination.

The polyester may contain a constituent derived from a monofunctional compound such as lauryl alcohol or phenyl isocyanate. The polyester may contain a constituent derived from a trifunctional compound such as trimellitic acid, pyromellitic acid, glycerol, pentaerythritol, or 2,4-dioxybenzoic acid as long as the polymer are not excessively branched nor crosslinked but are substantially linear. Furthermore, the polyester may contain a small amount of a constituent derived from an aromatic hydroxycarboxylic acid such as p-hydroxybenzoic acid, m-hydroxybenzoic acid, or 2,6-hydroxynaphthoic acid; p-aminophenol; or p-aminobenzoic acid unless the advantages of the present invention are reduced.

In view of mechanical strength, productivity, and handling, the polyester is preferably at least one selected from the group consisting of polyethylene terephthalate, polyethylene 2,6-naphthalate, a copolymer of these polyesters, and a derivative of one of these polyesters. The polyethylene terephthalate or polyethylene 2,6-naphthalate contains at least 80 mole percent of an acid constituent derived from terephthalic acid or 2,6-naphthalene dicarboxylic acid, respectively, and may further contain a small amount of an acid constituent derived from another dicarboxylic acid. The polyethylene terephthalate or polyethylene 2,6-naphthalate contains at least 80 mole percent of a diol constituent derived from ethylene glycol and may further contain a small amount of a constituent derived from another diol.

In view of formability, heat resistance, hydrolyzability, processing stability, and dimensional stability, the lower limit of the intrinsic viscosity of the polyester is preferably 0.50 dl/g or more, more preferably 0.55 dl/g or more, and further more preferably 0.6 dl/g or more. The upper limit thereof is preferably 2.0 dl/g or less, more preferably 1.4 dl/g or less, and further more preferably 1.0 dl/g or less.

The polyphenylene sulfide (PPS) preferably contains 80% or more of a phenylene sulfide constituent and more preferably 90% or more on a mole basis. When the content of the phenylene sulfide constituent is 80 mole percent or more, the PPS has high crystallinity and heat transition temperature; thus, achieving satisfactory heat resistance, dimensional stability, mechanical properties, and dielectric properties. The PPS may further contain a unit having a copolymerizable sulfide bond unless the content of the phenylene sulfide constituent is less than the above value. Examples of such a unit include a trifunctional unit such as trihalobenzene, an ether unit, a sulfone unit, a ketone unit, a metha-bonding unit, an aryl unit with a substituent such as an alkyl group, a biphenyl unit, a terphenyl unit, a vinylene unit, and a carbonate unit. Those units may be used alone or in combination. A random or block copolymer may be used.

In order to achieve good thermal adhesiveness and hygroscopic dimensional stability in addition to the above advantages of the PPS, the resin composition preferably has a PPS content of 60 percent by weight or more. When the PPS content is 60 percent by weight or more, the resin composition has the same advantages as those of the PPS. The resin composition may further contain a polymer other than the PPS, an inorganic or organic filler, a lubricant, and/or a colorant unless the PPS content is less than the above value.

The resin composition principally containing the PPS preferably has a melt viscosity of 500 to 50000 poise at a temperature of 300°C and a shear rate of 2000 $sec^{-1}$ and more preferably 1000 to 20000 poise.

It is critical that the thermoplastic resin composition-containing layer be biaxially oriented. This layer has strength sufficient for various applications because of the biaxial orientation.

It is critical that the first laminated film of the present invention include at least another one of film layers that includes a network structure. The laminated film has a low dielectric constant and good cushion properties because this layer includes the network structure or a porous structure. Since the laminated film has low stiffness, the film has high morphological stability. Furthermore, since the thermal expansion of the film is low, the film has high thermal dimensional stability.

The network structure has a configuration in which linear elements having a fibrillar shape, a rod shape, or a bead shape extend in film layer are connected to each other so as to form a network. Alternatively, the network structure has a configuration in which connected pores extend in parallel to a surface of the film in the longitudinal and/or transverse direction of the film to form a pseudo-network. In the network structure, the elements may be curved or partly disconnected from each other unless the advantages of the present invention are reduced.

The network structure may extend in the thickness direction of the film or the connected pores may be arranged in the thickness direction thereof.

The linear elements may contain a non-ductile resin composition described below or a non-ductile material such as a liquid-crystalline polymer, described below, contained in the non-ductile resin composition.

The linear elements having a fibrillar shape, a rod shape, or a bead shape preferably have a minor diameter of 5 nm to 100 μm, more preferably 50 nm to 10 μm, and further more preferably 0.1 to 5 μm when observed by electron micrography. FIG. 1 shows the network structure, wherein thick line represents the linear elements and D represents the minor diameter of the linear elements. When the minor diameter thereof is 100 μm or less, the laminated film has high formability, low surface roughness, and high flatness and is therefore suitable for various applications. Although the minor diameter thereof may be smaller, the linear elements actually have a minor diameter of 5 nm or more.

The network structure-including film layer may include a plurality of networks having different sizes or the linear elements may have different minor diameters or may include fine networks. In this case, the largest minor diameter of the linear elements is preferably controlled within the preferable range described above.

In order to achieve the advantages of the present invention, the network structure preferably has porosity of 20% to 80%, more preferably 30% to 70%, and further more preferably 30% to 60% on an area basis.

The term "at least another one layer" specified herein includes no sheet of non-woven fabric but a film.

The configuration involving the network structure or pores described above is common to the second laminated film of the present invention.

The network structure or pores described above can be formed because the network structure-including film layer contains the non-ductile resin composition.

In the second laminated film of the present invention, it is critical that at least another one layer contain the non-ductile resin composition.

The non-ductile resin composition specified herein is defined as a composition that has an elongation of 50% or less when measured at 100°C by "Measurement Method" described in Examples described below. That is, such a composition has a stress-strain curve, determined by a tensile test, having a steep slope. The non-ductile resin composition-containing film layer and the thermoplastic resin composition-containing layer are joined to each other and then biaxially stretched, whereby the network structure or the pores can be formed.

In particular, the non-ductile resin composition preferably contains a liquid-crystalline polymer that is not ductile. Alternatively, the network structure-including film layer of the first laminated film preferably contains such a liquid-crystalline polymer.

An example of the liquid-crystalline polymer is a polyester copolymer including one selected from the group consisting of an aromatic oxycarbonyl unit, an aromatic dioxy unit, an aromatic dicarbonyl unit, and an alkylene dioxy unit.

Commercially available examples of the liquid-crystalline polymer include "Siveras" (produced by Toray Industries Inc.), "Vectra" (produced by Polyplastics Co., Ltd.), "Zenite" (produced by Du Pont Kabushiki Kaisha), "Sumikasuper" (produced by Sumitomo Chemical Co., Ltd.), "Xydar" (produced by Solvay Advanced Polymers KK), "UENO LCP" (produced by Ueno Fine Chemicals Industry), and "Titan" (produced by Eastman Chemical Company).

In view of a structural unit, preferable examples of the liquid-crystalline polymer include a polyester copolymer having the following units (I), (II), (III), and (IV), a polyester copolymer having the following units (I), (III), and (IV), and a polyester copolymer having the following units (I), (II), and (IV):

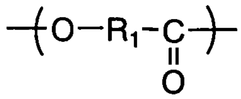

(I)

$\{O-R_2-O\}$ (II)

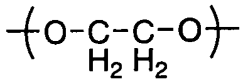

(III)

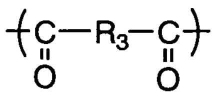

(IV)

wherein $R_1$ represents

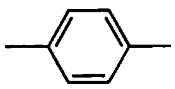

and / or

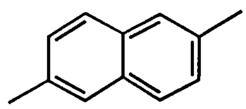

$R_2$ represents at least one selected from the group consisting of

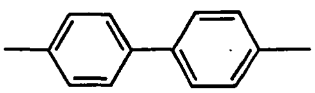

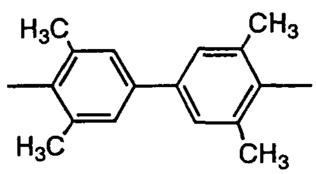

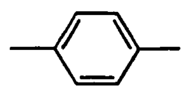

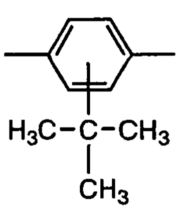

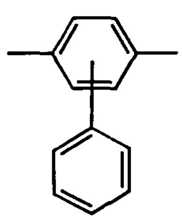

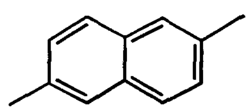

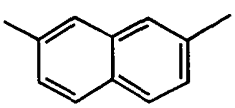

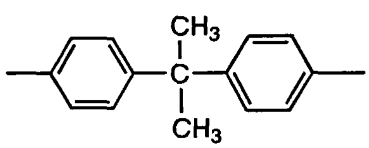

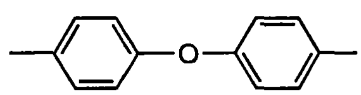

and $R_3$ represents at least one selected from the group consisting of

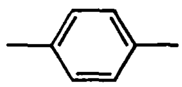

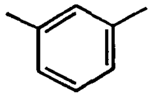

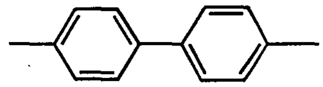

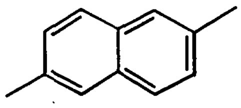

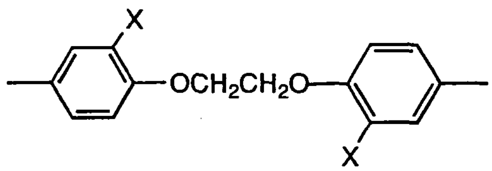

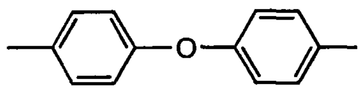

where X represents hydrogen or chlorine.

In the polyester copolymer having units (I), (II), and (IV), $R_1$ is particularly preferably

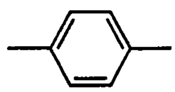

In the polyester copolymer having units (I), (III), and (IV), it is particularly preferable that $R_1$ be

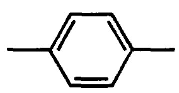

and $R_3$ be

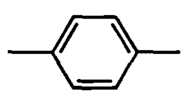

In the polyester copolymer having units (I), (II), (III), and (IV), it is particularly preferable that $R_1$ be

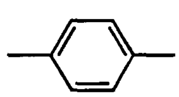

$R_2$ be

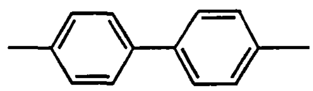

and $R_3$ be

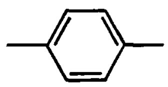

In those polyester copolymers, units (II) and (IV) form each polymer repeating unit and units (III) and (IV) also form each polymer repeating unit. That is, in those polyester copolymers, the number of moles of unit (IV) is substantially equal to the number of moles of unit (II), the number of moles of unit (III), or the sum of the number of moles of unit (II) and the number of moles of unit (III).
The term "substantially equal" covers that the number of carboxyl terminals is slightly greater than or less than that of hydroxyl terminals; that is, the number of moles of unit (IV) is not exactly equal to the sum of the number of moles of unit (II) and the number of moles of unit (III).
In the polyester copolymer having units (I), (II), (III), and (IV), the percentage of the sum of the number of moles of unit (I) and that of unit (II) in the sum of the number of moles of unit (I), that of unit (II), and that of unit (III) is preferably 5% to 95%, more preferably 30% to 90%, and further more preferably 50% to 80%. The percentage of the number of moles of unit (III) in the sum of the number of moles of unit (I), that of unit (II), and that of unit (III) is preferably 5% to 95%, more preferably 10% to 70%, and further more preferably 20% to 50%. In view of fluidity, the molar ratio of unit (I) to unit (II) is preferably 75:25 to 95:5 and more preferably 78:22 to 93:7.
In the polyester copolymer having units (I), (III), and (IV), the percentage of the number of moles of unit (I) in the sum of the number of moles of unit (I) and that of unit (III) is preferably 5% to 95% and more preferably 50% to 80%.
The polyester copolymer having units (I), (II), and (IV) is preferably prepared by blending the polyester copolymer having units (I), (II), (III), and (IV) and polyester copolymer having units (I), (III), and (IV). In this polymer blend, the percentage of the sum of the number of moles of unit (I) and that of unit (II) in the sum of the number of moles of unit (I), the number of moles of unit (II), and that of unit (III) is preferably 5% to 95%, more preferably 30% to 90%, and further more preferably 50% to 80%.
The polyester copolymers, which are examples of the liquid-crystalline polymer, may have a unit, other than units (I) to (IV), derived from a copolymerizable compound. Examples of such a copolymerizable compound include aromatic dicarboxylic acids such as 3,3'-diphenyl dicarboxylic acid and 2,2'-diphenyl dicarboxylic acid; aliphatic dicarboxylic acids such as adipic acid, azelaic acid, sebacic acid, and dodecanedioic acid; alicyclic dicarboxylic acids such as hexahydroterephthalic acid; aromatic diols such as chlorohydroquinone, methylhydroquinone, 4,4'-dihydroxydiphenyl sulfone, 4,4'-dihydroxydiphenyl sulfide, and 4,4'-dihydroxybenzophenone; aliphatic or alicyclic diols such as 1,4-butanediol, 1,6-hexanediol, neopentyl glycol, 1,4-cyclohexanediol, and 1,4-cyclohexane dimethanol; aromatic hydroxycarboxylic acids such as m-hydroxybenzoic acid and 2,6-hydroxynaphthoic acid; p-aminophenol; and p-aminobenzoic acid.
In order to readily form the network structure or the pores, the liquid-crystalline polymer preferably has a fluid point of 200°C to 360°C. In view of the blending with a non-liquid-crystalline polyester described below, the liquid-crystalline polymer more preferably has a fluid point of 230°C to 320°C.
The non-ductile resin composition may further contain a non-ductile polymer other than the liquid-crystalline polymer. Examples of such a non-ductile polymer include polyolefin, polycarbonate, polystyrene, polyether imide, polyether ketone, polyethersulfone, polysulfone, and polylactic acid.
In a laminated film of the present invention, the non-ductile resin composition preferably further contains an additional polymer other than the non-ductile polymer. Alternatively, the network structure-including film layer included in the first laminated film of the present invention preferably contains such an additional polymer. When the additional polymer is used, the network structure or the pores can be efficiently formed in the thermoplastic resin composition-containing layer by biaxially stretching the laminated film.
In view of the adhesion between these layers and the advantages of the present invention, the additional polymer is preferably the same as a polymer contained in the thermoplastic resin composition contained in a layer that is in contact with the network structure-including film layer or the non-ductile resin composition-containing film layer. Since the thermoplastic resin composition preferably contains polyester as described above, the additional polymer is

preferably a non-liquid-crystalline polyester. The non-liquid-crystalline polyester has a constituent derived from an acid such as an aromatic dicarboxylic acid, an alicyclic dicarboxylic acid, or an aliphatic dicarboxylic acid and a constituent derived from a diol.

In view of the processing stability of the laminated film and the blending with the liquid-crystalline polymer, the non-liquid-crystalline polyester, which is blended with the liquid-crystalline polymer, preferably has an intrinsic viscosity of 0.55 to 3.0 dl/g and more preferably 0.60 to 2.0 dl/g.

The lower limit of the content of the liquid-crystalline polymer in the network structure-including film layer or the non-ductile resin composition is preferably 20% or more, more preferably 30% or more, further more preferably 35% or more, and still further more preferably 40% or more on a weight basis. The upper limit is preferably 90% or less, more preferably 85% or less, further more preferably 80% or less, and still further more preferably 70% or less on a weight basis. When the liquid-crystalline polymer content is 20 percent by weight or more, the network structure or the pores can be formed. When the liquid-crystalline polymer content is 90 percent by weight or less, breakage can be prevented from occurring during film formation.

The content of the liquid-crystalline polymer in the laminated film is preferably 3% to 30%, more preferably 5% to 25%, and further more preferably 7% to 23% on a weight basis. When the liquid-crystalline polymer content of the laminated film is three percent by weight or more, the network structure or the pores can be securely formed; hence, the laminated film has improved advantages such as satisfactory density, good cushion properties, high flexibility, and high flatness. When the liquid-crystalline polymer content thereof is 30 percent by weight or less, breakage can be prevented from occurring during the stretching of the laminated film.

The number of layers arranged in a laminated film of the present invention is preferably two to 1000. In view of the advantages, workability, and productivity of the laminated film, the film preferably has the following layer arrangement: B/A/B, C/B/A/B/C, C/B/A/B, or the like, wherein A represents the network structure-including film layer or the non-ductile resin composition-containing film layer and C and B represents the biaxially oriented layers containing the thermoplastic resin composition. That is, the biaxially oriented layers are preferably placed on both faces of the layer represented by A. In particular, the three-layer arrangement B/A/B, in which the biaxially oriented layers which contain the same resin composition and which has the same thickness are placed on both faces of the layer represented by A, is preferable, because the laminated film can be prevented from being distorted during the processing thereof and the flatness of the film can therefore be maintained.

A laminated film of the present invention may contain a nucleating agent, a pyrolysis inhibitor, a heat stabilizer, an antioxidant, an ultraviolet absorber, an antistatic agent, a flame retardant, pigment, or dye unless the advantages of the present invention are reduced.

In order to impart slipability, wear resistance, and/or scratch resistance to surfaces of the laminated film, the film may contain an organic lubricant such as fatty ester or wax, a surfactant, and/or inorganic or organic particles for forming surface irregularities. A catalyst may be added to the laminated film during polymerization, whereby internal particles may be allowed to remain therein.

Such inorganic particles may contain an oxide such as silicon dioxide, aluminum oxide, titanium oxide, magnesium oxide, or zirconia; a composite oxide such as clay, mica, kaolin, talc, or montmorillonite; a carbonate such as calcium carbonate or barium carbonate; a sulfate such as calcium sulfate or barium sulfate; a titanate such as barium titanate or potassium titanate; or a phosphate such as calcium phosphate. Examples of silicon dioxide include wet- or dry-process silica and colloidal silica and the particles may be spherical or porous.

Such organic particles are preferably partly incompatible with a resin contained in the film. Examples of the organic particles include vinyl particles such as polystyrene or crosslinked-polystyrene particles, styrene-acrylic particles, acrylic crosslinked particles, and styrene-methacrylic crosslinked particles; benzoguanamine-formaldehyde particles; silicon particles; and polytetrafluoroethylene particles.

The surface roughness of the laminated film can be controlled by adjusting the size, content, and shape of the inorganic or organic particles. The average size of the particles is preferably 0.01 to 3 μm and the content of the particles in the laminated film is preferably 0.001 to 3 percent by weight. One kind of particles may be used alone or two or more kinds of particles having different sizes may be used in combination.

In usual, a laminated film of the present invention preferably has a thickness of 500 μm or less and more preferably 0.5 to 400 μm. In view of thin-film applications and/or handling, the thickness of the film is preferably 10 to 300 μm and more preferably 20 to 200 μm. The film thickness is preferably 2.0 to 10 μm for magnetic tape applications, 0.5 to 15 μm for capacitor applications, 12 to 250 μm for circuit or release liner applications, and 75 to 400 μm for electrical insulation applications.

The lower limit of the percentage of the thickness of the network structure-including film layer in the thickness of the laminated film or the lower limit of the percentage of the non-ductile resin composition-containing film layer in the laminated film is preferably 1% or more, more preferably 10% or more, further more preferably 15% or more, still further more preferably 20% or more, and most preferably 30% or more. The upper limit is preferably 90% or less, more preferably 80% or less, further more preferably 75% or less, still further more preferably 70% or less, and most

preferably 60% or less. When the lower limit is 1% or more, the laminated film has high thermal dimensional stability. When the lower limit is 10% or more, the laminated film has low density and therefore has good cushion properties. When the upper limit is 90% or less, the laminated film is hard to break.

It is critical that the second laminated film of the present invention has a density of 0.2 to 1.2. Also, the first laminated film of the present invention preferably has such a density. The laminated films of the present invention more preferably have a density of 0.3 to 1.0 and further more preferably 0.4 to 0.7. When the laminated films have a density of 1.2 or less, the films have a sufficient number of pours and therefore have good cushion properties; hence, the advantages of the present invention can be achieved. When the laminated films have a density of 0.2 or more, the number of the pours in the films is not excessive; hence, the strength and dimensional stability of the films are well balanced.

In a laminated films of the present invention, the longitudinal (MD) Young's modulus and transverse (TD) Young's modulus thereof are preferably 2 to 7 GPa. The lower limits of the moduli are preferably 2.5 GPa and more preferably 3 GPa. The upper limits of the moduli are preferably 6 GPa and more preferably 5 GPa. When the moduli are 7 GPa or less, the laminated film can be prevented from being distorted or curled, that is, the film has high dimensional stability. When the moduli are 2 GPa or more, the laminated film is firm and easy to handle.

In a laminated film of the present invention, the longitudinal (MD) heat shrinkage and transverse (TD) heat shrinkage thereof are preferably 0% to 2% at 150°C, in view of heat resistance. The upper limits of the heat shrinkage are more preferably 2.0% or less, further more preferably 1.0% or less, still further more preferably less than 1.0%, and most preferably 0.5% or less. When upper limits of the heat shrinkage are 2.0% or less, the laminated film has high heat resistance and thermal dimensional stability. When the heat shrinakge are 1.0% or less, the laminated film has high flatness. The lower limits of the heat shrinkage are preferably 0.01% or more. When the lower limits thereof are 0.01% or more, the film can be prevented from being wrinkled due to the expansion of the film and the flatness of the film can be prevented from being deteriorated.

In a laminated film of the present invention, the longitudinal (MD) thermal expansion coefficient and transverse (TD) thermal expansion coefficient thereof are preferably 3 to 45 ppm/°C. The lower limits of the coefficients are preferably 4 ppm/°C or more, more preferably 5 ppm/°C or more, and further more preferably 10 ppm/°C or more. The upper limits of the coefficients are preferably 35 ppm/°C or less, more preferably 30 ppm/°C or less, further more preferably 25 ppm/°C or less, and still further preferably 20 ppm/°C or less. When the thermal expansion coefficients are controlled within the above range, the film can be prevented from being distorted or curled due to heat in a step of processing the film for circuit applications or release liner applications.

A laminated film of the present invention preferably has a cushion factor of 10% to 50%, more preferably 15% to 45%, and further more preferably 20% to 40%. When the cushion factor thereof is 10% or more, the film is flexible; hence, a building material, such as wallpaper, including the film is easy to process. Furthermore, cost per area can be reduced. When the cushion factor is 50% or less, the strength and dimensional stability of the film can be well balanced and the film is superior in productivity.

A laminated film of the present invention preferably has a dielectric constant of 1.3 to 3.0 at 10 kHz and 30°C, more preferably 1.5 to 2.7, and further more preferably 1.7 to 2.5. When the dielectric constant thereof is 3.0 or less, currents can be prevented from leaking from an electrical insulation material including the film; hence, electric losses and heat generation due to the losses can be minimized; hence, the advantages of the present invention can be achieved. In order to balance the strength and productivity of the film by appropriately controlling the porosity of the film, it is sufficient that the dielectric constant be reduced to about 1.3.

A laminated film of the present invention may further include a polymer layer made of, for example, polycarbonate, polyolefin, polyamide, polyvinylidene chloride, or an acrylic polymer. Such a polymer layer may be joined to another layer of the film directly or with an adhesive layer placed therebetween.

A laminated film of the present invention may be subjected to heat treatment, molding, surface treatment, lamination, coating, printing, embossing, or etching.

A laminated film of the present invention is suitable for various industrial uses such as process materials, release materials, print materials, molding materials, building materials, magnetic recording materials, circuit materials, and electrical insulation materials.

In a laminated film of the present invention, the network structure or the porous structure can be formed as described below. A method for producing a laminated film according to the present invention includes a step of coextruding at least two resin compositions, one of the compositions being thermoplastic, another one being non-ductile, and a step of forming pores in a layer containing the non-ductile resin composition by biaxial stretching.

Polyethylene terephthalate contained in the thermoplastic resin composition or used as the non-liquid-crystalline polyester can be produced by any one of methods described below.

(1) A method in which terephthalic acid and ethylene glycol are subjected to esterification to produce low-molecular weight polyethylene terephthalate oligomers, which are subjected to polycondensation using a catalyst such as

antimony trioxide or a titan compound.

(2) A method in which dimethyl terephthalate and ethylene glycol are subjected to transesterification to produce oligomers, which are subjected to polycondensation using a catalyst such as antimony trioxide or a titan compound.

The esterification of method (1) proceeds in the absence of any catalyst. However, the transesterification of method (2) is preferably allowed to proceed using a catalyst such as a compound containing manganese, calcium, magnesium, zinc, lithium, or titanium. After the transesterification is substantially terminated, a phosphorus compound may be used to deactivate the catalyst used in this reaction. Examples of such a phosphorus compound include phosphorous acid, phosphoric acid, tris phosphate, phosphonic acid, and phosphonate. Those compounds may be used alone or in combination.

The esterification and the transesterification are preferably performed at 130°C to 260°C and the polycondensation is preferably performed at 220°C to 300°C under high vacuum conditions.

In particular, a method for producing polyethylene terephthalate is as follows: terephthalic acid and ethylene glycol are subjected to esterification or dimethyl terephthalate and ethylene glycol are subjected to transesterification, bis-β-hydroxyethyl terephthalate (BHT) is thereby produced, and the BHT is fed to a polymerization tank and then subjected to polymerization by heating the BHT to 280°C under vacuum conditions. Polyester having an intrinsic viscosity of about 0.5 is obtained in this step and then formed into pellets, which are pre-crystallized at 180°C or less and then subjected to solid polymerization at a temperature of 190°C to 250°C and a pressure of about 133 Pa (1 mmHg) for ten to 50 hours.

Some of the above additives may be used in any step between the esterification or the transesterification and the polycondensation.

A procedure for allowing polyethylene terephthalate to contain the particles is preferably as follows: the particles are dispersed in ethylene glycol and the resulting ethylene glycol is polymerized with terephthalic acid. In order to disperse the particles in the ethylene glycol, water sol or alcohol sol prepared to produce the particles is preferably added to the ethylene glycol without drying. Alternatively, the following procedure is preferable: slurry containing the particles is directly mixed with polyethylene terephthalate pellets and the mixture is kneaded with a vented twin-screw kneading extruder.

In order to control the particle content, master chips with high particle content is preferably prepared by any one of the above procedures in advance and then mixed with chips containing substantially no particles during film formation.

PPS, which is a thermoplastic resin, can be prepared by allowing p-dichlorobenzene to react with sodium sulfide at 230-280°C in a polar solvent such as N-methyl-2-pyrrolidone (NMP) under high pressure conditions. In this reaction, it is preferable to use a polymerization regulator such as caustic potassium or alkali metal carboxylate. A polymer prepared by the polymerization is cooled and then converted into water slurry, which is filtrated with a filter, whereby polymer powder is obtained. The powder is mixed with an aqueous solution containing acetate or the like at 30-100°C for 10-60 minutes. The resulting powder is cleaned with ion-exchanged water maintained at 30-80°C and then dried several times, whereby powdery PPS can be obtained. The PPS is preferably cleaned with NMP at an oxygen partial pressure of 1.3 MPa (10 Torr) or less and more preferably 665 Pa (5 Torr) or less. The resulting PPS is cleaned with ion-exchanged water maintained at 30-80°C several times and then dried at a reduced pressure less than or equal to 665 Pa (5 Torr). The PPS prepared as described above is substantially a linear polymer and the melt crystallization temperature of the PPS is 160°C to 190°C. Hence, the PPS can be readily formed into a stretchable film.

The polyester copolymer, which is an example of the liquid-crystalline polymer contained in the non-ductile resin composition, is preferably produced by method (3) or (4) described below if the copolymer does not include unit (III). However, if the copolymer includes unit (III), the copolymer is preferably produced by method (5) described below.

(3) A method in which a diacylate of an aromatic dihydroxy compound such as p-acetoxybenzoic acid, 4,4'-diacetoxybiphenyl, or 4,4'-diacetoxybenzene and an aromatic dicarboxylic acid such as terephthalic acid are subjected to polycondensation in which acetic acid is produced.

(4) A method in which acetic anhydride is allowed to react with an aromatic dihydroxy compound such as p-hydroxybenzoic acid, 4,4'-dihydroxybiphenyl, or hydroquinone and an aromatic dicarboxylic acid such as terephthalic acid to acylate phenolic hydroxyl groups of these compounds and the resulting compounds are subjected to polycondensation in which acetic acid is produced.

(5) A method in which polymers or oligomers of a polyester such as polyethylene terephthalate or bis (β-hydroxyethyl) esters of an aromatic dicarboxylic acid such as bis (β-hydroxyethyl) terephthalate are subjected to the same reaction as that used in method (1) or (2) described above.

Although the polycondensation used in methods (3) to (5) proceeds in the absence of any catalyst, the following compound is preferably used in the polycondensation in some cases: a metal compound such as tin acetate,

tetrabutyl titanate, potassium acetate, sodium acetate, antimony trioxide, or metallic magnesium.

Unit (I) described above can be derived from, for example, p-hydroxybenzoic acid and/or 6-hydroxy-2-naphthoic acid. Unit (II) can be derived from, for example, an aromatic dihydroxy compound such as 4,4'-dihydroxybiphenyl, 3,3',5,5'-tetramethyl-4,4'-dihydroxybiphenyl, hydroquinone, t-butylhydroquinone, phenylhydroquinone, 2,6-dihydroxynaphthalene, 2,7-dihydroxynaphthalene, 2,2'-bis(4-hydroxyphenyl)propane, or 4,4'-dihydroxydiphenyl ether. Unit (III) can be derived from, for example, ethylene glycol. Unit (IV) can be derived from, for example, an aromatic dicarboxylic acid such as terephthalic acid, isophthalic acid, 4,4'-diphenyl dicarboxylic acid, 2,6-naphthalene dicarboxylic acid, 1,2-bis(phenoxy)ethane-4,4'-dicarboxylic acid, 1,2-bis(2-chlorophenoxy)ethane-4,4'-dicarboxylic acid, or 4,4'-diphenyl ether dicarboxylic acid.

In the present invention, if the liquid-crystalline polymer is blended with an additional polymer, the following technique may be used: a technique for melt-kneading the liquid-crystalline polymer and the additional polymer in advance, pelletizing the mixture, and then melt-extruding the pellets into master chips; a technique for melt-kneading the liquid-crystalline polymer and the additional polymer to melt-extrude the mixture; or another technique. It is preferable to prepare such master chips because the polymers are uniformly mixed and a high-quality film having good formability can therefore be prepared using the master chips.

A procedure for preparing the master chips to form the unstretched laminated film will now be described. In this procedure, polyethylene terephthalate (PET) is used as the thermoplastic resin and liquid-crystalline polyester, UENO LCP 5000, produced by Ueno Fine Chemicals Industry is used as the liquid-crystalline polymer. UENO LCP 5000 has unit (I).

In the master chips, the ratio of the liquid-crystalline polymer to the PET preferably ranges from 95:5 to 50: 50 on a weight basis.

The liquid-crystalline polymer and the thermoplastic resin may be separately melted in different melt extruders and then mixed. Alternatively, powdery raw materials may be mixed with a mixing unit such as a Henschel mixer, a ball mixer, a blender, or a tumbler in advance and then melt-kneaded with a melt-kneader.

The melt-kneader is preferably of a twin-screw kneading extruder type.

Pellets of the liquid-crystalline polymer pellets of the PET are mixed at a ratio suitable for preparing the master chips. The mixture is fed to a vented twin-screw kneading extruder and then melt-kneaded at a temperature of 280°C to 320°C. In order to prevent mixing failure, the vented twin-screw kneading extruder preferably includes two double- or triple-thread screws. The residence time of the mixture in the extruder is preferably one to five minutes.

In order to adjust the content of the liquid-crystalline polymer in the non-ductile resin composition to a desired value, the master chips prepared as described above are mixed with chips of the PET. This mixture is vacuum-dried at about 180°C for three hours or more and then fed to the extruder including a compression zone heated to a temperature of 270°C to 320°C. Since the master chips are mixed with the PET chips, the temperature of the compression zone is more preferably 290°C to 310°C.

On the other hand, particles are mixed with PET and this mixture is dried and then fed to another extruder.

In order to prevent the laminated film from containing contaminants, foreign matters and/or deteriorated polymer matters are preferably removed from the extruders by filtration when the polymers are melt-extruded from the extruders. Filters used in this step are preferably made of sintered metal, porous ceramic, sand, or gauze.

In order to constantly feed the polymers, the extruders preferably include gear pumps.

The melted polymers extruded from the extruders are joined to each other in a feed block in a layered manner and then formed into a sheet-shaped extrudate by discharging the resulting polymers from a slit of a T-die. The sheet-shaped extrudate is solidified by allowing the extrudate to be in contact with a cooling drum (a casting roll) having a surface temperature of 20°C to 70°C, whereby an unstretched film that is not substantially oriented is obtained.

The unstretched film is biaxially stretched, whereby a layer containing the thermoplastic resin is biaxially oriented and cracks are formed in a layer containing the non-ductile resin composition. Examples of a stretching process include a sequential biaxial stretching process (a stretching process including a step of performing longitudinal stretching and then performing transverse stretching) and a simultaneous biaxial stretching process (a stretching process including a step of simultaneously performing longitudinal stretching and transverse stretching), which may be used alone or in combination.

Stretching conditions may be determined depending on the arrangement of layers, components of resin compositions contained in the layers and are preferably as described below.

The draw ratio is preferably 1.2 to 6.0 and more preferably 2.5 to 4.5 when the film is stretched in the longitudinal or transverse direction in one or more steps.

The stretching temperature is preferably 90°C to 180°C and more preferably Tg to Tg + 40°C, wherein Tg represents the glass transition point (°C) of the thermoplastic resin composition.

The film may be further stretched depending on uses and properties of the film. The redraw ratio is preferably 1.1 or more in the longitudinal and/or transverse direction.

The heat treatment temperature of the stretched film is preferably 150°C to Tm and more preferably 200°C

to 245°C, wherein Tm represents the melting point (°C) of the thermoplastic resin composition. The heat treatment time of the stretched film is preferably 0.3 to 30 seconds.

In order to achieve the advantages of the present invention, the film is relaxed by 1% to 10% and more preferably 9% or less in the longitudinal and/or transverse direction during the heat treatment of the film or the cooling of the heat-treated film.

The film rolled is preferably aged at a temperature of 50°C to 120°C for five minutes to 500 hours.

A procedure for stretching the following film will now be described: a film having a three-layer structure in which layers containing the thermoplastic resin composition are placed on both faces of a layer containing the non-ductile resin composition containing the liquid-crystalline polymer. The film is stretched by the sequential biaxial stretching process.

An unstretched polyester film is preferably heated with a group of heating rolls and then stretched in multiple steps. In particular, before longitudinal stretching is performed, the film is preferably slightly stretched in the longitudinal direction. The slight stretch is effective in releasing the stress held in polymer chains and the stress held among such polymer chains to assist subsequent stretching and is therefore useful in forming a network structure or a porous structure in the non-ductile resin composition-containing layer. The draw ratio of the slight stretching is preferably 1.05 to 1.8, more preferably 1.1 to 1.5, and further more preferably 1.15 to 1.3. The temperature of the slight stretching is preferably Tg + 10°C to Tg + 70°C, more preferably Tg + 15°C to Tg + 60°C, and further more preferably Tg + 20°C to Tg + 50°C, wherein Tg represents the glass transition point (°C) of the thermoplastic resin composition.

The draw ratio of the longitudinal (MD) stretching is preferably two to five, more preferably 2.5 to 4.5, further more preferably three to four, including that of the slight stretching. The draw ratio of the longitudinal stretching does not include that of longitudinal restretching described below. The temperature of the longitudinal stretching is preferably Tg to Tg + 60°C, more preferably Tg + 5°C to Tg + 55°C, and further more preferably Tg + 10°C to Tg + 50°C, wherein Tg represents the glass transition point (°C) of the thermoplastic resin composition.

After the film is longitudinally stretched, the resulting film is preferably cooled with a group of cooling rolls maintained at a temperature of 20°C to 50°C.

The film is preferably stretched with, for example, a tenter in the transverse (TD) direction. The film is introduced into the tenter in such a manner that both ends of the film are retained with clips, whereby the film is transversely stretched. The draw ratio of the transverse stretching is preferably 2.0 to 6.0, more preferably 3.0 to 5.0, further more preferably 3.5 to 4.5. The draw ratio of the transverse stretching does not include that of the longitudinal restretching. The temperature of the transverse stretching is preferably Tg to Tg + 80°C, more preferably Tg + 10°C to Tg + 70°C, and further more preferably Tg + 20°C to Tg + 60°C, wherein Tg represents the glass transition point (°C) of the thermoplastic resin composition.

After the film is transversely stretched, the resulting film is preferably cooled with a group of cooling rolls maintained at a temperature of 20°C to 50°C.

The resulting film may be further longitudinally restretched and/or transversely restretched depending on properties of the film.

The film can be longitudinally restretched by heating the film with a group of heating rolls. The draw ratio of the longitudinal restretching is preferably 1.1 to 2.5, more preferably 1.2 to 2.4, further more preferably 1.3 to 2.3. The temperature of the transverse stretching is preferably Tg to Tg + 100°C, more preferably Tg + 20°C to Tg + 80°C, and further more preferably Tg + 40°C to Tg + 60°C, wherein Tg represents the glass transition point (°C) of the thermoplastic resin composition.

The film can be transversely restretched with a tenter. The draw ratio of the transverse restretching is preferably 1.1 to 2.5, more preferably 1.15 to 2.2, further more preferably 1.2 to 2.0. The temperature of the transverse stretching is preferably Tg to 250°C, more preferably Tg + 20°C to 240°C, and further more preferably Tg + 40°C to 220°C, wherein Tg represents the glass transition point (°C) of the thermoplastic resin composition.

The stretched film is preferably heat-set in such a manner that the film is tensed or transversely relaxed. The heat-setting temperature is preferably 150°C to 250°C, more preferably 170°C to 245°C, and further more preferably 190°C to 240°C. The heat-setting time is preferably 0.2 to 30 seconds.

The resulting film is preferably cooled at a temperature of 40°C to 180°C in such a manner that the film is transversely relaxed. In order to reduce the transverse heat shrinkage, the relaxation rate of the film is preferably 1% to 10%, more preferably 2% to 8%, and further more preferably 3% to 7%.

The resulting film is cooled to room temperature and then rolled, whereby a laminated film of the present invention is obtained.

Examples

[Measurement/Evaluation Method]

(1) Intrinsic Viscosity

Samples dissolved in ortho-chlorophenol were measured for solution viscosity at 25°C with an Ostwald viscometer and the viscosity of the solvent was also measured. The intrinsic viscosity η of the samples was calculated using an equation below. The number of the samples was three and obtained measurements were averaged.

$$\eta sp/C = [\eta] + K[\eta]^2 \cdot C$$

wherein ηsp = (solution viscosity / solvent viscosity) - 1, C represents the weight of a polymer dissolved in 100 ml of the solvent and is usually equal to 1.2 g/100 ml, and K represents the Huggins constant (0.343).

(2) Glass Transition Point (Tg)

Samples were measured for specific heat according to JIS K 7121 in a quasi-isothermal mode under the following conditions using the following instrument.
Instrument: Temperature-modulated DSC manufactured by TA Instruments, Inc.

Measurement Conditions

Heating Temperature: 270 to 570 K (RCS Cooling)
Temperature Calibration: Melting Point of High-purity Indium and Melting Point of High-purity Tin
Temperature Modulation Amplitude: ± 1 K
Temperature Modulation Cycle: 60 seconds
Heating Step: 5 K
Sample Weight: 5 mg
Sample Container: Aluminum Open Container (22 mg)
Reference Container: Aluminum Open Container (18 mg)

The glass transition points (Tg) of the three samples were calculated using the following equation and then averaged:

Tg = (Extrapolated Initial Glass Transition Temperature

+ Extrapolated Final Glass Transition Temperature) / 2

(3) Melting Point (Tm)

A differential scanning calorimeter, DSC RDC 220, manufactured by Seiko Instruments Inc. and a data analyzer, Disk Station SSC/5200, manufactured by Seiko Instruments Inc. were used. Each 5 mg sample was placed on an aluminum pan, melted at 300°C for five minutes, solidified by quenching, and then heated from room temperature at a rate of 20°C/min. The temperature of an endothermic peak, observed in this step, corresponding to the melting of the sample was defined as the melting point(Tm). The number of the measured samples was three and obtained measurements were averaged.

(4) Non-ductility of Resin Composition

Each resin composition was placed on a polyimide film ("Kapton" produced by Du Pont-Toray Co., Ltd.), compressed at 300°C (or 400°C if the composition has a melting point of 300°C or more) for ten seconds with a pressure of 10 $kg/cm^2$ using a pressing machine, and then degassed every 0.2 millisecond eight times, whereby a sheet was prepared. The sheet obtained was processed into samples having a width of 10 mm and a length of 20 mm. Three of the samples were measured for tensile strength at break at 100°C and a tensile rate of 100 mm/min according to ASTM

D-882. The number of the measured samples was three. A resin composition having an average elongation of 50% or less was determined to be non-ductile.

(5) Residence Time of Polymer during Melt-extruding

A carbon black tracer was added to each polymer placed in a feed section of an extruder such that the content of the tracer in the polymer was one percent by weight. It was observed that the tracer and the polymer were discharged from the top of a T-die through the extruder, a short pipe, and then a filter. The residence time of the polymer was determined by the formula (t2 - t1), wherein t1 represents the time when the tracer was fed to the feed section and t2 represents the time when the tracer, which was discharged from the die together with the polymer, disappeared from the discharged polymer. The center of the cast film was measured for light transmittance at a wavelength of 550 nm with a U-3410 spectrophotometer manufactured by Hitachi, Ltd. and the time t2 was defined as the time t satisfying the equation F(t) = 0.98. Function F(t) is defined as follows:

F(t) = (the light transmittance of the cast film at the time t when the carbon black tracer was added thereto) / (the light transmittance of the cast film containing no carbon black tracer)

(6) Breakage during Film Formation

Films were checked for breakage. A rating A was given to a film having no breakage, a rating B was given to a film having a very small number of breakages, a rating C was given to a film having some breakages, and a rating D was given to a film having a large number of breakages.

(7) Density of Films

Samples having a size of 4 cm × 5 cm were prepared by cutting each film and then measured for density with a density meter (SD-120L produced by Mirage Trading Co., Ltd.) by a water immersion method according to JIS K 7112 in such a manner that each sample was immersed in 23°C water for one minute and then measured for density. Obtained measurements were converted into densities at 25°C.

(8) Dielectric Constant of Films

Measurement performed according to JIS C 2318. Aluminum was deposited on both faces of each film, which was used to prepare samples. The samples were measured for dielectric constant at 30°C and 10 kHz with a dielectric analyzer (DEA 2970 manufactured by TA Instruments, Inc.). The number of the measured samples was three and obtained measurements were averaged.

(9) Young's Modulus

Measurement was performed according to ASTM D-882 with an Instron-type tensile testing machine (a film tensile tester, Tensilon AMF/RTA-100, manufactured by Orientec Co., Ltd.). Measurement conditions described below were used. Ten samples were measured for Young's modulus and obtained measurements were averaged.

Sample Size: a width of 10 mm and a chuck distance of 100 mm
Strain Rate: 10 mm/minute
Measurement Environment: a temperature of 23°C and a relative humidity of 65%

(10) Heat shrinkage

Measurement was performed according to JIS C 2318 under conditions below. Ten samples were subjected to the measurement and obtained measurements were averaged.

Sample Size: a width of 10 mm and a gauge length of 200 mm
Measurement Conditions: a temperature of 150°C, a treatment time of 30 minutes, and a load of zero

The heat shrinkage of each sample was determined at 150°C using the following equation:

$$\text{Heat shrinkage (\%)} = [(L0 - L) / L0] \times 100$$

wherein L0 represents the gauge length of the unheated sample and L represents the gauge length of the heated sample.

(11) Thermal Expansion Coefficient

A thermomechanical analyzer (TMA/SS 6100 manufactured by Seiko Instruments Inc.) was used. A load of 3 g was applied to each sample having a width of 4 mm and a length (chuck distance) of 20 mm and the resulting sample was heated from room temperature to 170°C at a rate of 10°C/min and then maintained for ten minutes. The resulting sample was cooled to 40°C at a rate of 10°C/min and then maintained for 20 minutes. The thermal expansion coefficient $\alpha$ (1/°C) of the sample was determined from the difference between the length of the sample cooled to 150°C and that of the sample cooled to 50°C using the following equation:

$$\alpha = \{(L150 - L50) / L0\} / \Delta T$$

wherein L0 represents the initial length of the sample maintained at 23°C, L150 represents the length of the sample cooled to 150°C, L50 represents the length of the sample cooled to 50°C, and $\Delta T$ represents the difference in temperature (150 - 50 = 100)

(12) Dimensional Stability of Films

Each film for measurement was affixed to the polyimide side of a copper-clad polyimide film according to JIS C 6472 with an adhesive containing general-purpose polyvinyl chloride and a plasticizer and these films were pressed against each other at 160°C with a pressure of 2.9 MPa (30 kg/cm$^2$) for 30 minutes with rolls. A 25 cm square sample was prepared by cutting the resulting films and placed on a table. The four corners of the sample were measured for warpage and obtained measurements were averaged. A rating A was given to a sample having a warpage of less than 5 mm, a rating B was given to a sample having a warpage of 5 to less than 10 mm, and a rating C was given to a sample having a warpage of 10 mm or more. A sample having a rating of A or B is acceptable.

(13) Cushion Factors of Films

Some 5 cm square samples were prepared by cutting each film. Each sample was measured for thickness with a dial gauge (manufactured by Mitutoyo Corporation) equipped with a standard gauge head (No. 2109-10) including a 3 mm diameter steel ball in such a manner that a load of 50 g was applied to an upper portion of the sample and the resulting sample was maintained for 30 seconds. Furthermore, the sample was measured for thickness in such a manner that a load of 500 g was applied to another portion of the sample and the resulting sample was maintained for 30 seconds. The cushion factor was determined using an equation below. The number of the measured samples was five and obtained measurements were averaged.

Cushion Factor = [1 - (Thickness of Sample Loaded with

500 g) / (Thickness of Sample Loaded with 50 g)] × 100

(14) Flatness

Some 25 cm square samples were prepared by cutting films. Each sample was treated at 160°C for 30 minutes in such a manner that the sample was placed on a flat table under no load. The resulting sample was placed on a cork table and flattened with a bar covered with non-woven fabric, whereby air present between the table and the sample was completely removed. After the sample was allowed to stand for three minutes, the sample was observed and the

number of portions of the sample was counted, the portions being apart from the cork table. A rating A was given to a sample having five or less apart portions, a rating B was given to a sample having six to ten apart portions, a rating C was given to a sample having 11 to 15 apart portions, and a rating D was given to a sample having 16 or more apart portions.

(15) Current Leaking from Electrical Insulation Material

Slot liners and wedges were prepared from films and mounted in motors. Currents leaking from the motors were measured. The motors contained refrigerant AC 9000 and oil VG 32. A rating A was given to a film included in a motor of which the leak current was less than 0.8 mA, a rating B was given to a film included in a motor of which the leak current was 0.8 to 1 mA, and a rating C was given to a film included in a motor of which the leak current was more than 1 mA.

(16) Percentage of Layer Thickness

Samples prepared from laminated films were coated with an epoxy resin and then cut in the longitudinal and transverse directions of the films. Pictures of cut surfaces of each sample were taken with a scanning electron microscope. The thickness of the film and the thickness of a specific layer included in the film were measured using the pictures. The percentage of the specific layer thickness in the film thickness was determined.

(17) Porosity of Layer and Diameter of Linear Elements

Samples prepared from films were cut in parallel to a surface of each film, whereby cut surfaces of layers, included in the films, having pores or the like were exposed. A picture of each cut surface was taken with a scanning electron microscope. The image data of this picture was analyzed with image analysis software, whereby the porosity of the layer was determined.

When the cut surface had a network structure, 100 randomly selected portions of linear elements included in the network structure were measured for minor diameter. The diameter of the network structure was determined using the following equation:

$$D = \Sigma Di / 100$$

wherein D represents the average diameter of the network structure and Di represents the minor diameter of the linear elements.

[Example 1]

(Synthesis of PET)

Calcium acetate, which was an esterification catalyst, was added to a mixture, heated to 140°C, containing 100 parts by weight of dimethyl terephthalate and 60 parts by weight of ethylene glycol. The resulting mixture was subjected to esterification by heating the mixture to 230°C in such a manner that methanol was distilled out of the mixture. Antimony trioxide, which was a polymerization catalyst, and phosphorus acid, which was a thermal stabilizer, were added to the esterification product. The resulting esterification product was fed to a polycondensation vessel. The pressure in a reaction system including the vessel was gradually reduced to 0.1 kPa while the system was being heated from 230°C to 290°C. The esterification product was subjected to polymerization at 290°C and a reduced pressure in such a manner that methanol was distilled out of the product, whereby polyethylene terephthalate (referred to as non-particle PET) containing substantially no particles was synthesized. The PET had an intrinsic viscosity of 0.62, a glass transition point of 78°C, and a melting point of 255°C.

(Preparation of Resin Composition B)

Aggregated silica particles with an average size of 2.5 μm were added to chips of the non-particle PET, whereby master chips containing 2% by weight of the particles were prepared. The master chips were mixed with the non-particle PET chips such that the content of the particles in the mixture was 0.1% by weight. The mixture was vacuum-dried at 180°C for three hours and then fed to an extruder I including a compression zone heated to 280°C.

Resin compositions prepared in examples and comparative examples by the same procedure as described

above are referred to as "resin compositions B" and a layer containing a resin composition B is referred to as "a B layer".

(Preparation of Resin Composition A)

Fifty parts by weight of the non-particle PET chips and 50 parts by weight of UENO LCP 5000 (referred to as LCP1), which was a liquid-crystalline polymer produced by Ueno Fine Chemicals Industry, were vacuum-dried at 180°C for three hours and then fed to a vented co-rotating twin-screw extruder (a screw diameter of 25 mm and a screw length/screw diameter ratio of 28) including a kneading zone heated to 290°C. The mixture was melt-extruded into strands at a screw speed of 200 rpm and a residence time of two minutes. The strands were cooled with cool water and then cut, whereby polymer blend chips were prepared. The evaluation for non-ductility showed that the elongation was 20%. The polymer blend chips were vacuum-dried at 180°C for three hours and then fed to an extruder II including a compression zone heated to 280°C.

Resin compositions prepared in the examples and the comparative examples by the same procedure as described above are referred to as "resin compositions A" and a layer containing a resin composition A is referred to as "an A layer".

[Preparation of Unstretched Laminated Film)

Resin compositions A and B each melted in corresponding extruders were each filtrated through corresponding filters and then fed to a rectangular junction block (a feed block) for forming a three-layer structure, whereby a three-layer extrudate including a B layer, an A layer, and a B layer arranged in that order was prepared. The flow rate of each polymer passing through the junction block was adjusted by controlling the rotation speed of a gear pump placed in a line for feeding the polymer to control the amount of the extruded polymer such that a stretched, relaxed laminated film finally have a thickness of 50 μm and the ratio of the B layer thickness to the A layer thickness to the B layer thickness is 1:1:1.

The molten polymers arranged in that order were extruded and the extrudate was cooled by bring the extrudate into intimate contact with a cast drum having a surface temperature of 25°C in such a manner that the extrudate was statically charged, whereby the extrudate was solidified. An unstretched laminated film was prepared by rolling the resulting extrudate at a draft ratio of 8, the draft ratio being defined as the ratio of the width of a die slit to the thickness of an unstretched film.

(Stretching and Relaxation)

The unstretched film was stretched with a stretching machine including a plurality of groups of heated rolls in the longitudinal direction of the film using a difference in rotation speed between the rolls under the following conditions: a stretching temperature of 100°C and a draw ratio of 3.5. Both ends of the resulting film were retained with clips and the film was stretched at a stretching temperature of 105°C and a draw ratio of 3.7 with a tenter in the transverse direction of the film.

The resulting film was heat-treated at 235°C for three seconds, relaxed by 3% in the transverse direction in a cooling zone maintained at 150°C, further relaxed by 1% in the transverse direction in a cooling zone maintained at 100°C, and then cooled to room temperature. Film edges were removed, whereby a laminated film (the A layer and the B layers has a thickness of 16.7 μm; that is, the percentage of the thickness of the A layer in the thickness of the film was 33%) with a thickness of 50 μm was prepared.

The film of this example was not broken during film formation and the productivity of the film was high.

The configuration and properties of the obtained laminated film are shown in Tables 1 to 3. Since the A layer made of the resin composition A containing the liquid-crystalline polymer has the network structure, the film is flexible and has a small thermal expansion coefficient and high dimensional stability; hence, the film is suitable for circuit materials. The film has a small dielectric constant. Fibrils that are the linear elements included in the network structure have an average diameter of 3.5 μm.

[Example 2]

A laminated film having a thickness of 50 μm was prepared in the same manner as described in Example 1 except that the film included B layers having a thickness of 12.5 μm and an A layer, placed between the B layers, having a thickness of 25 μm.

[Example 3]

Liquid-crystalline polyester (referred to as LCP2), which was a liquid-crystalline polymer, was used to prepare a resin composition A. This polyester had a melting point of 265°C and a molecular weight of 18000 and was prepared using a composition below.

| (Composition Used to Prepare LCP2 by Copolymerization) | |
|---|---|
| p-hydroxybenzoic acid | 56.8 molar percent |
| 4,4'-dihydroxybiphenyl | 5.9 molar percent |
| ethylene glycol | 15.7 molar percent |
| terephthalic acid | 21.6 molar percent |

The ratio of PET contained in the resin composition A to the LCP2 was 30:70 on a weight basis. The evaluation for non-ductility showed that the elongation was 15%. A laminated film was prepared in the same manner as described in Example 1 except those described above.

[Example 4]

(PPS Resin)

A linear PPS resin (Ryton T1881 having a glass transition point of 92°C and a melting point of 285°C) produced by Toray Industries Inc. was used instead of the non-particle PET of Example 1.

(Preparation of Resin Composition B)

In the PPS resin, 0.2% of a silica powder having an average particle size of 0.7 μm and 0.05% of calcium stearate were uniformly dispersed on a weight basis, whereby a resin composition B was prepared. The resin composition B was vacuum-dried at 180°C for three hours and then fed to an extruder I including a compression zone heated to 295°C.

(Preparation of Resin Composition A)

Fifty parts by weight of the PPS resin (Ryton T1881) and 50 parts by weight of the LCP1 were vacuum-dried at 180°C for three hours and then fed to a vented co-rotating twin-screw extruder (a screw diameter of 25 mm and a screw length/screw diameter ratio of 28) including a kneading zone heated to 305°C. The mixture was melt-extruded into strands at a screw speed of 200 rpm and a residence time of 90 seconds. The strands were cooled with cool water and then cut, whereby polymer blend chips were prepared. The evaluation for non-ductility showed that the elongation was 10%.

The polymer blend chips were used to prepare a resin composition A, which was vacuum-dried at 180°C for three hours and then fed to an extruder II including a compression zone heated to 300°C.

(Preparation of Unstretched Laminated Film)

An unstretched laminated film was prepared in the same manner as described in Example 1 except that those resin compositions A and B were used and the draft ratio was five.

(Stretching and Relaxation)

The unstretched film was stretched at a stretching temperature of 105°C and a draw ratio of 3.1 with the stretching machine used in Example 1 in the longitudinal direction of the film. The resulting film was stretched at a stretching temperature of 115°C and a draw ratio of 3.2 with a tenter in the transverse direction of the film in the same manner as described in Example 1.

The resulting film was heat-treated at 255°C for three seconds, relaxed by 4% in the transverse direction in a cooling zone maintained at 150°C, further relaxed by 1% in the transverse direction in another cooling zone maintained at 100°C, and then cooled to room temperature. Film edges were removed, whereby a laminated film (an A layer and B layers had a thickness of 16.7 μm; that is, the percentage of the thickness of the A layer in the thickness

of the film was 33%) with a thickness of 50 µm was prepared. The film of this example was not broken during film formation and the productivity of the film was high.

The configuration and properties of the obtained laminated film are shown in Tables 1 to 3. Since the A layer made of the resin composition A containing the liquid-crystalline polymer has the network structure, the film has a small Young' modulus and a thermal expansion coefficient greatly less than that of a monolayer PPS film described in Comparative Example 2; hence, the film is suitable for circuit materials. The film has a small dielectric constant. Linear elements included in the network structure have an average fibril diameter of 3 µm.

[Comparative Example 1]

A PET film with a thickness of 50 µm was prepared in the same manner as described in Example 1 except that only the resin composition B used in Example 1 was used to prepare the film.

[Comparative Example 2]

A PPS film with a thickness of 50 µm was prepared in the same manner as described in Example 4 except that only the resin composition B used in Example 4 was used to prepare the film.

[Comparative Example 3]

The ratio of PET contained in a resin composition A to LCP1 was 95:5 on a weight basis. The evaluation for non-ductility showed that the elongation was 500%. A laminated film was prepared in the same manner as described in Example 1 except those described above.

In the laminated film of Comparative Example 3, since the resin composition A was not non-ductile, the A layer had no network structure. This film had properties similar to those of the PET film of Comparative Example 1.

[Comparative Example 4]

A laminated film was prepared in the same manner as described in Example 1 except that the ratio of PET contained in a resin composition A to LCP1 was 5:95 on a weight basis.

This film was frequently broken; that is, this film could not be readily formed. An A layer included in the film had no network structure and the film had unsatisfactory surface properties.

Table 1 shows the layer arrangements of the films of Examples 1 to 4 and Comparative Examples 1 to 4.

Table 1

| | Layer Arrangements | B Layer | A Layer | | Content of Liquid-Crystalline Polymer in Laminated Film (percent by weight) |
|---|---|---|---|---|---|
| | | | Resin Composition (weight ratio) | Thickness Percentage (%) | |
| Example 1 | B/A/B | PET | PET/LCP1(50/50) | 33 | 6 |
| Example 2 | B/A/B | PET | PET/LCP1(50/50) | 50 | 10 |
| Example 3 | B/A/B | PET | PET/LCP2(30/70) | 33 | 9 |
| Example 4 | B/A/B | PPS | PPS/LCP1(50/50) | 33 | 8 |
| Comparative Example 1 | B | PET | - | 0 | 0 |
| Comparative Example 2 | B | PPS | - | 0 | 0 |
| Comparative Example 3 | B/A/B | PET | PET/LCP1(95/5) | 33 | 2 |
| Comparative Example 4 | B/A/B | PET | PET/LCP1(5/95) | 33 | 25 |

Tables 2 and 3 show the evaluation results of the films of Examples 1 to 4 and Comparative Examples 1 to 4.

Table 2

| | Network Structure of A Layer | Breakage during Film Formation | Density | Dielectric Constant |
|---|---|---|---|---|
| Example 1 | Present | A | 0.80 | 2.6 |
| Example 2 | Present | A | 0.70 | 1.7 |
| Example 3 | Present | B | 0.61 | 1.9 |
| Example 4 | Present | A | 0.78 | 2.1 |
| Comparative Example 1 | Not Present | B | 1.39 | 3.3 |
| Comparative Example 2 | Not Present | B | 1.40 | 3.0 |
| Comparative Example 3 | Not Present | A | 1.38 | 3.2 |
| Comparative Example 4 | Not Present | C | - | - |

Table 3

| | Young's Modulus (MD/TD) (GPa) | Heat Shrinkage (MD/TD) (%) | Thermal Expansion Coefficient (MD/TD) (ppm/°C) | Dimensional Stability | Leaking Current |
|---|---|---|---|---|---|
| Example 1 | 3.2/3.4 | 0.4/0.2 | 24/22 | A | B |
| Example 2 | 3.0/3.2 | 0.2/0.2 | 18/17 | A | A |
| Example 3 | 3.2/3.4 | 0.4/0.2 | 21/20 | A | A |
| Example 4 | 3.1/3.3 | 0.3/0.2 | 28/24 | A | A |
| Comparative Example 1 | 4.4/4.5 | 1.6/0.9 | 34/32 | C | C |
| Comparative Example 2 | 4.2/4.3 | 1.5/0.6 | 53/52 | C | C |
| Comparative Example 3 | 4.2/4.4 | 1.5/0.5 | 35/31 | C | C |
| Comparative Example 4 | - | - | - | - | - |

[Example 5]

(Synthesis of PET)

To a mixture of 194 parts of dimethyl terephthalate and 124 parts of ethylene glycol, 0.1 parts of magnesium acetate tetrahydrate was added on a weight basis. The mixture was subjected to esterification by heating the mixture to 230°C in such a manner that methanol was distilled out of the mixture. To the esterification product, 0.05 parts by weight of antimony trioxide and an ethylene glycol solution containing 0.05 parts by weight of trimethyl phosphate were added. This mixture was agitated for five minutes. The reaction system was heated from 230°C to 290°C and the pressure in the system was reduced to 0.1 kPa while the oligomers were agitated at 30 rpm. It took 60 minutes to heat the system to the final temperature and to reduce the system pressure to the final pressure. Polymerization was performed for three hours and then terminated by replacing the atmosphere in the reaction system with nitrogen gas at the point of time when the agitation torque reached a predetermined value. The reaction product was extruded into strands into cool water and the strands were cut, whereby pellets of polyethylene terephthalate (referred to as non-particle PET), containing substantially no particles, having an intrinsic viscosity of 0.62 were obtained. The non-particle PET had a glass transition point of 78°C and a melting point of 255°C.

(Preparation of Resin Composition B)

Aggregated silica particles with an average size of 2.5 μm were added to chips of the non-particle PET, whereby master chips containing 2% by weight of the particles were prepared. The master chips were mixed with the non-particle PET chips such that the content of the particles in the mixture was 0.1% by weight. The mixture was vacuum-dried at 180°C for three hours, whereby a resin composition B was prepared. The resin composition B was fed to an extruder I including a compression zone heated to 280°C.

(Preparation of Resin Composition A)

Fifty parts by weight of the non-particle PET chips and 50 parts by weight of LCP1 were vacuum-dried at 180°C for three hours and then fed to a vented co-rotating twin-screw extruder (a screw diameter of 25 mm and a screw length/screw diameter ratio of 28) including a kneading zone heated to 290°C. The mixture was melt-extruded into strands at a screw speed of 200 rpm and a residence time of two minutes. The strands were cooled with cool water and then cut, whereby polymer blend chips were prepared. The evaluation for non-ductility showed that the elongation was 20%. The polymer blend chips were vacuum-dried at 180°C for three hours, whereby a resin composition B was prepared. The resin composition B was fed to an extruder II including a compression zone heated to 280°C.

[Preparation of Unstretched Laminated Film)

The resin compositions A and B each melted in the corresponding extruders were each filtrated through corresponding filters and then fed to a rectangular junction block (a feed block) for forming a three-layer structure, whereby a three-layer extrudate including a B layer, an A layer, and a B layer arranged in that order was prepared. The flow rate of each polymer passing through the junction block was adjusted by controlling the rotation speed of a gear pump placed in a line for feeding the polymer to control the amount of the extruded polymer such that a stretched, relaxed laminated film finally have a thickness of 50 μm and the ratio of the B layer thickness to the A layer thickness to the B layer thickness is 20:60:20.

The molten polymers arranged in that order were extruded and the extrudate was cooled by bring the extrudate into intimate contact with a cast drum having a surface temperature of 25°C in such a manner that the extrudate was statically charged, whereby the extrudate was solidified. An unstretched laminated film was prepared by rolling the resulting extrudate at a draft ratio of 8, the draft ratio being defined as the ratio of the width of a die slit to the thickness of an unstretched film.

(Stretching and Relaxation)

The unstretched film was stretched at a stretching temperature of 105°C and a draw ratio of 1.2 with a roll-type stretching machine in the longitudinal direction of the film and then further stretched at a stretching temperature of 85°C and a draw ratio of 3.0. Furthermore, the resulting film was stretched at a stretching temperature of 100°C and a draw ratio of 4.0 with a tenter in the transverse direction of the film.

The resulting film was heat-treated at 230°C for ten seconds and then relaxed by 1% in the transverse direction at 200°C, whereby a laminated film with a thickness of 50 μm was prepared.

The configuration and properties of the obtained laminated film are shown in Tables 4 to 6. The laminated film is superior in dielectric constant, cushion factor, flexibility, thermal expansion coefficient, and flatness.

[Examples 6 to 9]

Laminated films were prepared in the same manner as described in Example 5 except that the content of the LCP1, which was a liquid-crystalline polymer, in each resin composition A was varied and the percentage of each A layer was varied as shown in Tables 4 to 6.

The configuration and properties of the obtained laminated films are shown in Tables 4 to 6. The laminated films are superior in dielectric constant, cushion factor, flexibility, thermal expansion coefficient, and flatness. The evaluation for non-ductility showed that the film of Example 6 had an elongation of 25%, the film of Example 7 had an

elongation of 40%, and the film of Example 8 had an elongation of 5%. In the films of Examples 6 to 8, the A layers containing the resin compositions A had pseudo-network structures in which connected pours were arranged in parallel to a surface of each film in the longitudinal direction of the film or in which network elements were partly disconnected. In the film of Example 9, the A layer had a network structure.

[Example 10]

The LCP2, which was a liquid-crystalline polymer, was used instead of the LCP1. The evaluation for non-ductility showed that the elongation was 30%. A laminated film was prepared in the same manner as described in Example 5.

The configuration and properties of the obtained laminated film are shown in Tables 4 to 6. This laminated film is superior in dielectric constant, cushion factor, flexibility, thermal expansion coefficient, and flatness.

[Example 11]

Liquid-crystalline polyester (referred to as LCP3), which was a liquid-crystalline polymer, was used. This polyester had a melting point of 220°C and was prepared using a composition below.

| Composition Used to Prepare LCP3 by Copolymerization | |
|---|---|
| p-hydroxybenzoic acid | 31.2 molar percent |
| 4,4'-dihydroxybiphenyl | 4.9 molar percent |
| ethylene glycol | 29.5 molar percent |
| terephthalic acid | 34.4 molar percent |

The evaluation for non-ductility showed that the elongation was 45%. A laminated film was prepared in the same manner as described in Example 5 except those described above.

The configuration and properties of the obtained laminated film are shown in Tables 4 to 6. This laminated film is superior in dielectric constant, thermal expansion coefficient, and flatness.

[Example 12]

The following resin was used to prepare a resin composition A instead of the LCP1 used in the Example 4: a liquid-crystalline resin (referred to as LCP4), Siveras®, having a melting point of 315°C, produced by Toray Industries Inc. The kneading zone of the vented co-rotating twin-screw extruder used in Example 4 was heated to 325°C. The evaluation for non-ductility showed that the elongation was 15%. A laminated film was prepared in the same manner as described in Example 4 except those described above.

The configuration and properties of the obtained laminated film are shown in Tables 4 to 6. This laminated film is superior in thermal expansion coefficient and dielectric constant.

[Example 13]

(Preparation of Resin Composition B)

A resin composition B was prepared in the same manner as described in Example 5 and then fed to the extruder I.

(Preparation of Resin Composition A)

Forty parts by weight of polymethylpentene (DX 820 produced by Mitsui Chemical) referred to as PMP was used instead of the liquid-crystalline polymer, LCP1, used in Example 5 and 60 parts by weight of PET prepared by copolymerizing 6% by weight of polyethylene glycol (PEG), used as a dispersant, having a molecular weight of 4000 was used instead of the non-particle PET used in Example 5. These polymers were mixed. The mixture was vacuum-dried at 180°C for three hours and then fed to a vented co-rotating twin-screw extruder (a screw diameter of 25 mm and a screw length/screw diameter ratio of 28) including a kneading zone heated to 290°C. The mixture was melt-extruded into strands at a screw speed of 200 rpm and a residence time of two minutes. The strands were cooled with cool water and then cut, whereby polymer blend chips were prepared. The evaluation for non-ductility showed that the

elongation was 45%. The polymer blend chips were vacuum-dried at 180°C for three hours, whereby a resin composition A was prepared. The resin composition A was fed to an extruder II including a compression zone heated to 280°C.

[Preparation of Unstretched Laminated Film)

The resin compositions A and B each melted in the corresponding extruders were each filtrated through corresponding filters and then fed to a multimanifold (a multilayer die) for forming a three-layer structure, whereby a three-layer extrudate including a B layer, an A layer, and a B layer arranged in that order was prepared. The flow rate of each polymer passing through the multimanifold was adjusted by controlling the rotation speed of a gear pump placed in a line for feeding the polymer to control the amount of the extruded polymer such that a stretched, relaxed laminated film finally have a thickness of 50 μm and the ratio of the B layer thickness to the A layer thickness to the B layer thickness is 20:60:20.

The molten polymers arranged in that order were extruded and the extrudate was cooled by bring the extrudate into intimate contact with a cast drum having a surface temperature of 25°C in such a manner that the extrudate was statically charged, whereby the extrudate was solidified. An unstretched laminated film was prepared by rolling the resulting extrudate at a draft ratio of 8, the draft ratio being defined as the ratio of the width of a die slit to the thickness of an unstretched film.

(Stretching and Relaxation)

The unstretched film was subjected to stretching and the like in the same manner as described in Example 5, whereby a laminated film was prepared.

The configuration and properties of the obtained laminated film are shown in Tables 4 to 6. This laminated film has a small dielectric constant and the thermal expansion coefficient and flatness of the film are acceptable.

[Example 14]

A laminated film was prepared in the same manner as described in Example 5 except that polyether imide (PEI), Ultem 1010, produced by GE Plastic was used instead of the liquid-crystalline polymer LCP1 used in Example 5.

The configuration and properties of the obtained laminated film are shown in Tables 4 to 6. This laminated film has a small dielectric constant and the thermal expansion coefficient and flatness of the film are acceptable.

[Comparative Examples 5 and 6]

Laminated films were prepared in the same manner as described in Example 5 except that the content of a liquid-crystalline polymer LCP1 in a resin composition A was varied and the percentage of the thickness of an A layer was varied as shown in Table 4.

The configuration and properties of the obtained laminated films are shown in Tables 5 and 6. These laminated films have a density outside the scope of the present invention and are inferior in dielectric constant, cushion factor, flexibility, thermal expansion coefficient, and flatness.

[Comparative Example 7]

A PET film with a thickness of 50 μm was prepared in the same manner as described in Example 5 except that only the resin composition B used in Example 5 was used to prepare the film.

The configuration and properties of the obtained laminated film are shown in Tables 5 and 6. This laminated film has is inferior in dielectric constant, cushion factor, flexibility, and thermal expansion coefficient.

Table 4

| | Layer Arrangements | B Layer | A Layer | | Content of Liquid-Crystalline Polymer in Laminated Film (percent by weight) |
|---|---|---|---|---|---|
| | | | Resin Composition (weight ratio) | Thickness Percentage (%) | |
| Example 5 | B/A/B | PET | PET/LCP1(50/50) | 60 | 12 |
| Example 6 | B/A/B | PET | PET/LCP1(65/35) | 75 | 10 |
| Example 7 | B/A/B | PET | PET/LCP1(72/28) | 80 | 10 |
| Example 8 | B/A/B | PET | PET/LCP1(10/90) | 15 | 3 |
| Example 9 | B/A/B | PET | PET/LCP1(50/50) | 50 | 6 |
| Example 10 | B/A/B | PET | PET/LCP2(50/50) | 60 | 12 |
| Example 11 | B/A/B | PET | PET/LCP3(50/50) | 60 | 12 |
| Example 12 | B/A/B | PPS | PPS/LCP4(50/50) | 60 | 12 |
| Example 13 | B/A/B | PET | PET/PMP (60/40) | 60 | - |
| Example 14 | B/A/B | PET | PET/PEI (50/50) | 60 | - |
| Comparative Example 5 | B/A/B | PET | PET/LCP1(70/30) | 15 | 2 |
| Comparative Example 6 | B/A/B | PET | PET/LCP1(50/50) | 80 | 32 |
| Comparative Example 7 | B | PET | - | 0 | 0 |

Table 5

| | Network Structure of A Layer | Density | Cushion Factor (%) | Dielectric Constant |
|---|---|---|---|---|
| Example 5 | Present | 0.56 | 30 | 1.7 |
| Example 6 | Present | 0.66 | 21 | 2.6 |
| Example 7 | Present | 0.72 | 17 | 2.8 |
| Example 8 | Present | 1.05 | 12 | 2.7 |
| Example 9 | Present | 0.68 | 23 | 1.6 |
| Example 10 | Present | 0.58 | 27 | 2.0 |
| Example 11 | Present | 0.70 | 18 | 2.7 |
| Example 12 | Present | 0.72 | 21 | 2.0 |
| Example 13 | Present | 0.45 | 35 | 1.5 |
| Example 14 | Present | 0.82 | 15 | 2.3 |
| Comparative Example 5 | Not Present | 1.23 | 7 | 2.9 |
| Comparative Example 6 | Not Present | 0.18 | 55 | 1.5 |
| Comparative Example 7 | Not Present | 1.38 | 5 | 3.3 |

Table 6

| | Young's Modulus (MD/TD) (GPa) | Heat shrinkage (MD/TD) (%) | Thermal Expansion Coefficient (MD/TD) (ppm/°C) | Flatness | Leaking Current |
|---|---|---|---|---|---|
| Example 5 | 2.7/2.8 | 0.3/0.2 | 17/16 | A | A |
| Example 6 | 3.1/3.2 | 0.4/0.2 | 18/17 | A | A |
| Example 7 | 3.6/3.8 | 0.5/0.2 | 22/23 | B | B |
| Example 8 | 3.8/4.2 | 0.7/0.3 | 26/25 | C | B |
| Example 9 | 3.0/3.0 | 0.3/0.2 | 18/17 | B | A |
| Example 10 | 3.3/3.5 | 0.3/0.2 | 17/16 | A | A |
| Example 11 | 3.7/3.8 | 0.2/0.2 | 24/22 | B | B |
| Example 12 | 3.2/3.4 | 0.3/0.2 | 24/23 | B | A |
| Example 13 | 2.4/2.3 | 0.4/0.2 | 32/31 | C | A |
| Example 14 | 3.0/3.2 | 0.2/0.2 | 38/36 | C | A |
| Comparative Example 5 | 4.1/4.6 | 1.2/0.5 | 31/31 | D | C |
| Comparative Example 6 | 1.4/1.5 | 0.4/0.3 | 13/12 | D | A |
| Comparative Example 7 | 4.5/5.0 | 2.1/0.9 | 35/33 | D | C |

[Comparative Example 8]

The preparation of a laminated film was attempted using the same resin compositions A and B as those used in Example 5 in the same manner as described in Example 5 except that an A layer, a B layer, and an A layer were arranged in that order. This arrangement was different from that described in Example 5.

An unstretched film was frequently broken while the film was being stretched. Therefore, no biaxially stretched laminated film could be prepared.

[Comparative Example 9]

The preparation of a laminated film was attempted using the same resin compositions A and B as those used in Example 5 in the same manner as described in Example 5 except that only two layers, that is, an A layer and a B layer, were formed and the ratio of the thickness of the A layer to the thickness of the B layer was 1:2.

An unstretched film was frequently broken while the film was being stretched. Therefore, no biaxially stretched laminated film could be prepared.

## Claims

1. A laminated film comprising at least two film layers, wherein at least one of the film layers contains a thermoplastic resin composition and is biaxially oriented and at least another one of the film layers includes a network structure.

2. The laminated film according to Claim 1, wherein the biaxially oriented film layers containing the thermoplastic resin composition are placed on both faces of the network structure-including film layer.

3. The laminated film according to Claim 1, wherein the network structure-including film layer contains a non-ductile resin composition.

4. The laminated film according to Claim 1, wherein the network structure-including film layer contains a liquid-crystalline polymer.

5. The laminated film according to Claim 4, wherein the network structure-including film layer further contains non-liquid-crystalline polyester.

6. The laminated film according to Claim 5, wherein the non-liquid-crystalline polyester is polyethylene terephthalate, polyethylene naphthalate, or a derivative of one of these polyesters.

7. The laminated film according to Claim 4, wherein the content of the liquid crystal polymer in the network structure-including film layer is 20 to 90 percent by weight.

8. The laminated film according to Claim 4, wherein the content of the liquid-crystalline polymer in the laminated film is three to 30 percent by weight.

9. The laminated film according to Claim 1, wherein the network structure-including film layer has a thickness equal to 1% to 90% of the thickness of the laminated film.

10. The laminated film according to Claim 9, wherein the network structure-including film layer has a thickness equal to 10% to 80% of the thickness of the laminated film.

11. The laminated film according to Claim 1, wherein the thermoplastic resin composition contained in the biaxially oriented film layers contains at least one selected from the group consisting of polyester, polyphenylene sulfide, polyether imide, polycarbonate, polyether ketone, polyethersulfone, polysulfone, and polylactic acid.

12. The laminated film according to Claim 1, wherein the longitudinal Young's modulus and transverse Young's modulus thereof are 2 to 7 GPa.

13. The laminated film according to Claim 1, wherein the longitudinal heat shrinkage and transverse heat shrinkage thereof are 0% to 2% at 150°C.

14. The laminated film according to Claim 1, wherein the longitudinal thermal expansion coefficient and transverse thermal expansion coefficient thereof are 3 to 45 ppm/°C.

15. A laminated film with a density of 0.2 to 1.2, comprising at least two film layers, wherein at least one of the film layers contains a thermoplastic resin composition and is biaxially oriented and at least another one of the film layers contains a non-ductile resin composition.

16. The laminated film according to Claim 15, wherein the biaxially oriented film layers are placed on both faces of the non-ductile resin composition-containing film layer.

17. The laminated film according to Claim 15, wherein the non-ductile resin composition contains a liquid-crystalline polymer.

**18.** The laminated film according to Claim 17, wherein the non-ductile resin composition further contains non-liquid-crystalline polyester.

**19.** The laminated film according to Claim 18, wherein the non-liquid-crystalline polyester is polyethylene terephthalate, polyethylene naphthalate, or a derivative of one of these polyesters.

**20.** The laminated film according to Claim 17, wherein the content of the liquid-crystalline polymer in the non-ductile resin composition is 20 to 90 percent by weight.

**21.** The laminated film according to Claim 17, wherein the content of the liquid-crystalline polymer in the laminated film is three to 30 percent by weight.

**22.** The laminated film according to Claim 15, wherein the non-ductile resin composition-containing film layer has a thickness equal to 1% to 90% of the thickness of the laminated film.

**23.** The laminated film according to Claim 22, wherein the non-ductile resin composition-containing film layer has a thickness equal to 10% to 80% of the thickness of the laminated film.

**24.** The laminated film according to Claim 15, wherein the thermoplastic resin composition contained in the biaxially oriented film layers contains at least one selected from the group consisting of polyester, polyphenylene sulfide, polyether imide, polycarbonate, polyether ketone, polyethersulfone, polysulfone, and polylactic acid.

**25.** The laminated film according to Claim 15, wherein the longitudinal Young's modulus and transverse Young's modulus thereof are 2 to 7 GPa.

**26.** The laminated film according to Claim 15, wherein the longitudinal heat shrinkage and transverse heat shrinkage thereof are 0% to 2% at 150°C.

**27.** The laminated film according to Claim 15, wherein the longitudinal thermal expansion coefficient and transverse thermal expansion coefficient thereof are 3 to 45 ppm/°C.

**28.** A method for producing a laminated film, comprising a step of coextruding at least two resin compositions, one of the compositions being thermoplastic, another one being non-ductile, and a step of forming cracks in a layer containing the non-ductile resin composition by biaxial stretching.

**29.** The method according to Claim 28, wherein the thermoplastic resin composition is contained in layers placed on both faces of the non-ductile resin composition-containing layer.

**30.** A circuit material comprising the laminated film according to Claim 1 or 15.

**31.** A release material comprising the laminated film according to Claim 1 or 15.

**32.** An electrically insulating material comprising the laminated film according to Claim 1 or 15.

FIG. 1

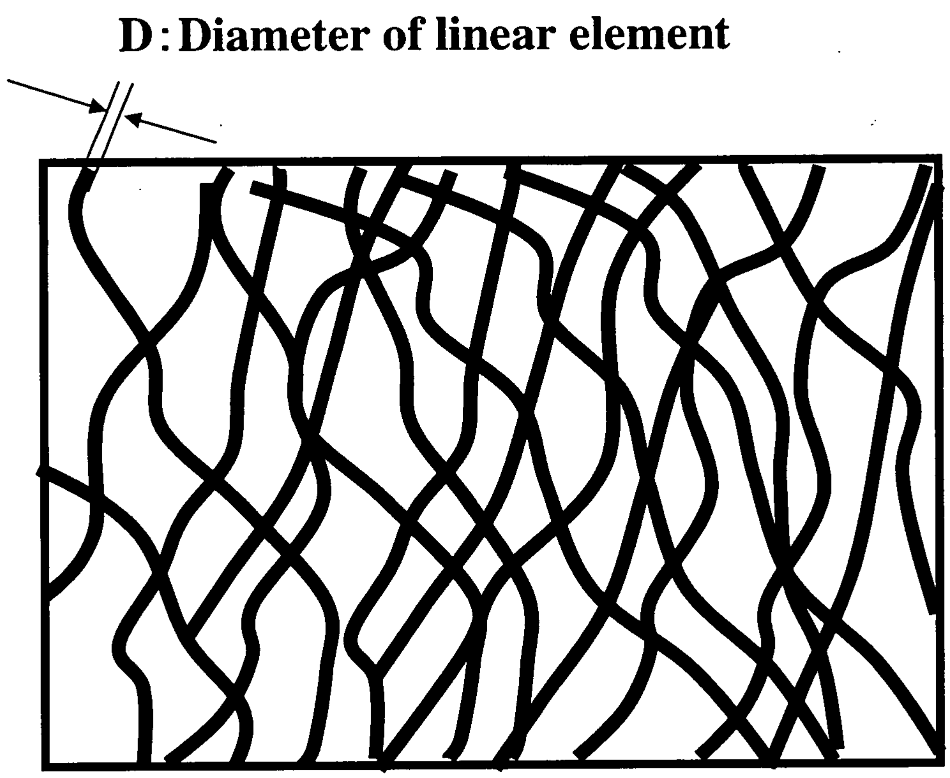

FIG. 2

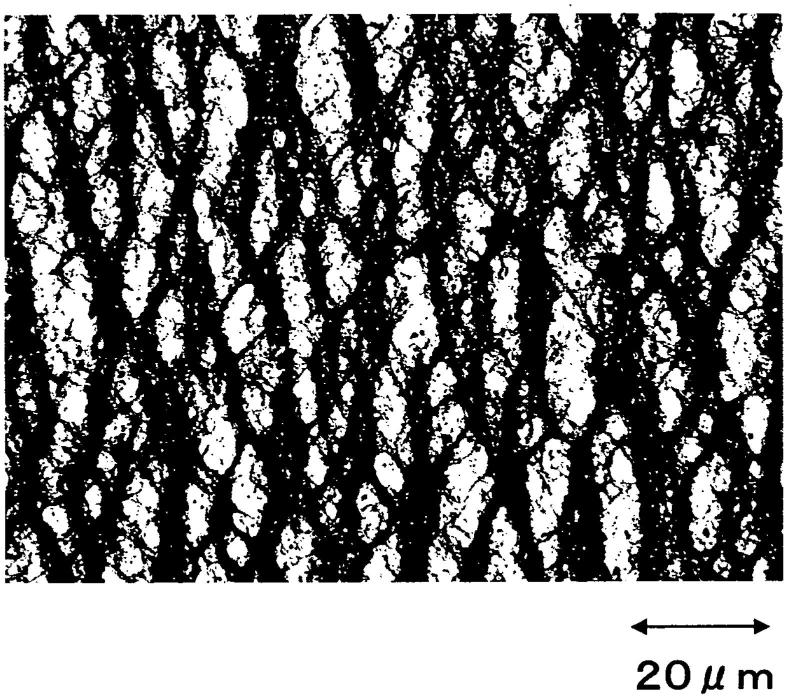

## INTERNATIONAL SEARCH REPORT

International application No.
PCT/JP03/16702

A. CLASSIFICATION OF SUBJECT MATTER
Int.Cl[7] B32B5/18, B32B27/08

According to International Patent Classification (IPC) or to both national classification and IPC

B. FIELDS SEARCHED

Minimum documentation searched (classification system followed by classification symbols)
Int.Cl[7] B32B1/00-35/00, C08J9/00-9/42

Documentation searched other than minimum documentation to the extent that such documents are included in the fields searched

| | | | |
|---|---|---|---|
| Jitsuyo Shinan Koho | 1926-1996 | Toroku Jitsuyo Shinan Koho | 1994-2004 |
| Kokai Jitsuyo Shinan Koho | 1971-2004 | Jitsuyo Shinan Toroku Koho | 1996-2004 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| P,X | JP 2003-136619 A (Toray Industries, Inc.), 14 May, 2003 (14.05.03), (Family: none) | 1-3,9-16, 22-32 |
| X | WO 01/016229 A (3M INNOVATIVE PROPERTIES CO.), 08 March, 2001 (08.03.01), & JP 2003-508571 A | 1-3,9-16, 22-32 |
| X | JP 10-24542 A (Diafoil Hoechst Co., Ltd.), 27 January, 1998 (27.01.98), (Family: none) | 1-32 |
| X | JP 2002-71913 A (Toyobo Co., Ltd.), 12 March, 2002 (12.03.02), (Family: none) | 1-32 |

[X] Further documents are listed in the continuation of Box C. [ ] See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 06 April, 2004 (06.04.04) | 20 April, 2004 (20.04.04) |
| Name and mailing address of the ISA/ Japanese Patent Office | Authorized officer |
| Facsimile No. | Telephone No. |

Form PCT/ISA/210 (second sheet) (July 1998)

**INTERNATIONAL SEARCH REPORT**

International application No.
PCT/JP03/16702

C (Continuation). DOCUMENTS CONSIDERED TO BE RELEVANT

| Category* | Citation of document, with indication, where appropriate, of the relevant passages | Relevant to claim No. |
|---|---|---|
| A | JP 2001-9977 A (Toray Industries, Inc.), 16 January, 2001 (16.01.01), (Family: none) | 1-32 |

Form PCT/ISA/210 (continuation of second sheet) (July 1998)

**INTERNATIONAL SEARCH REPORT**

International application No.
PCT/JP03/16702

Continuation of Box No.II of continuation of first sheet(1)

Consequently, claim 1 and claim 15 relate to different inventions, and thus this international application contains two inventions: the invention of claims 1-14, 30-32; and the invention of claims 15-29.

Form PCT/ISA/210 (extra sheet) (July 1998)

**INTERNATIONAL SEARCH REPORT**

International application No.
PCT/JP03/16702

**Box I Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box II Observations where unity of invention is lacking (Continuation of item 3 of first sheet)**

This International Searching Authority found multiple inventions in this international application, as follows:

The technical feature common to claim 1 and claim 15 is "a laminated film comprising at least two layers among which at least one layer is a biaxially oriented film composed of a thermoplastic resin composition". This multilayer film cannot be a special technical contribution over the prior art, since it is well-known as it is needless to cite documents and thus not novel. There is no technical relationship between the feature "at least one other layer having a network structure" of claim 1 and the feature "at least one other layer which is composed of an inductile resin composition and a specific gravity of 0.2-1.2 of the laminated film" of claim 15.

(Continued to extra sheet)

1. ☒ As all required additional search fees were timely paid by the applicant, this international search report covers all searchable claims.

2. ☐ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest** ☐ The additional search fees were accompanied by the applicant's protest.

☐ No protest accompanied the payment of additional search fees.

Form PCT/ISA/210 (continuation of first sheet (1)) (July 1998)